(19) Europäisches Patentamt
European Patent Office
Office européen des brevets

(11) **EP 2 602 836 A1**

(12) **EUROPEAN PATENT APPLICATION**
published in accordance with Art. 153(4) EPC

(43) Date of publication:
**12.06.2013 Bulletin 2013/24**

(51) Int Cl.:
**H01L 33/22** (2010.01)    **H01L 33/32** (2010.01)
**H01S 5/343** (2006.01)

(21) Application number: **11814318.9**

(22) Date of filing: **05.08.2011**

(86) International application number:
**PCT/JP2011/004466**

(87) International publication number:
**WO 2012/017686 (09.02.2012 Gazette 2012/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2010   JP 2010177915**

(71) Applicant: **Panasonic Corporation
Osaka 571-8501 (JP)**

(72) Inventors:
• **ISOZAKI, Akihiro
2-1-61, Shiromi
Chuo-ku
Osaka 540-6207 (JP)**
• **INOUE, Akira
2-1-61, Shiromi
Chuo-ku
Osaka 540-6207 (JP)**
• **YAMADA, Atsushi
2-1-61, Shiromi
Chuo-ku
Osaka 540-6207 (JP)**
• **YOKOGAWA, Toshiya
2-1-61, Shiromi
Chuo-ku
Osaka 540-6207 (JP)**

(74) Representative: **Grünecker, Kinkeldey,
Stockmair & Schwanhäusser
Leopoldstrasse 4
80802 München (DE)**

(54) **SEMICONDUCTOR LIGHT-EMITTING ELEMENT**

(57)    A semiconductor light-emitting element according to the present invention includes: an n-type nitride semiconductor layer **21**; a p-type nitride semiconductor layer **23**; an active layer region **22** which includes an m-plane nitride semiconductor layer and which is interposed between the n-and p-type nitride semiconductor layers; an n-type electrode **30** which is electrically connected to the n-type nitride semiconductor layer; a p-type electrode **40** which is electrically connected to the p-type nitride semiconductor layer; a light-emitting face, through which polarized light that has been produced in the active layer region is extracted out of this element; and a striped structure **50** which is provided for the light-emitting face and which has a plurality of projections that run in a direction that defines either an angle of 5 degrees to 80 degrees or an angle of -80 degrees to -5 degrees with respect to the a-axis direction of the m-plane nitride semiconductor layer.

*FIG.1*

**Description**

TECHNICAL FIELD

The present invention relates to a nitride-based semiconductor light-emitting element and more particularly relates to a semiconductor light-emitting element, of which the principal surface is an m plane.

BACRGROUND ART

A nitride semiconductor including nitrogen (N) as a Group V element is a prime candidate for a material to make a short-wave light-emitting element because its bandgap is sufficiently wide. Among other things, gallium nitride-based compound semiconductors have been researched and developed particularly extensively. As a result, blue-ray-emitting light-emitting diodes (LEDs), green-ray-emitting LEDs and semiconductor laser diodes made of gallium nitride based semiconductors have already been used in actual products (see Patent Documents Nos. 1 and 2).

In the following description, gallium nitride based compound semiconductors will be referred to herein as "nitride-based semiconductors". Nitride-based semiconductors include compound semiconductors, of which Ga is replaced either partially or entirely with at least one of aluminum (Al) and indium (In), and are represented by the compositional formula $Al_xGa_yIn_zN$ (where $0 \leq x, y, z \leq 1$ and $x + y + z = 1$).

By replacing Ga with Al or In, the band gap can be made either wider or narrower than that of GaN. As a result, not only short-wave light rays such as blue and green rays but also orange and red rays can be emitted as well. That is why by using a nitride-based semiconductor, a light-emitting element that emits a light ray, of which the wavelength is arbitrarily selected from the entire visible radiation range, is realizable theoretically speaking, and therefore, they hope to apply such nitride-based semiconductor light-emitting elements to image display devices and illumination units.

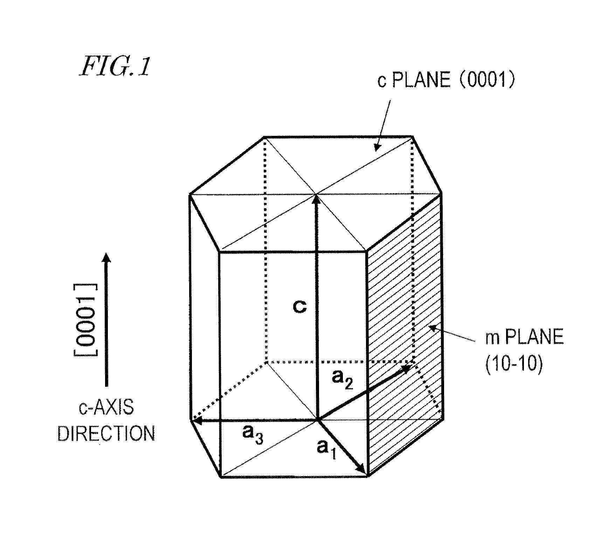

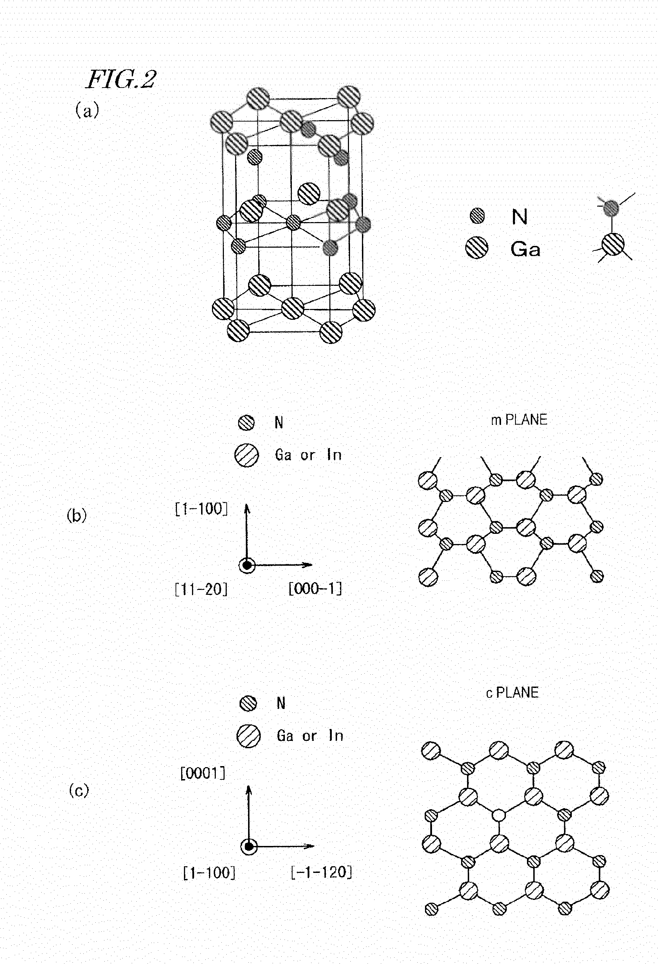

A nitride-based semiconductor has a wurtzite crystal structure. FIG. 1 illustrates the planes of a wurtzite crystal structure which are indicated by four indices (i.e., hexagonal indices). According to the four index notation, a crystal plane or orientation is represented by four primitive vectors **a1, a2, a3** and **c.** The primitive vector **c** runs in the [0001] direction, which is called a "c axis". A plane that intersects with the c axis at right angles is called either a "c plane" or a "(0001) plane". It should be noted that the "c axis" and the "c plane" are sometimes referred to as "C axis" and "C plane". FIG. **2(a)** illustrates the crystal structure of a nitride-based semiconductor by ball-stick model and FIG. **2(b)** indicates the positions of Ga and N in a nitride-based semiconductor crystal on a plane that intersects with the c-axis at right angles.

In the related art, in fabricating a semiconductor element using nitride-based semiconductors, a c-plane substrate, i.e., a substrate of which the principal surface is a (0001) plane, is used as a substrate on which nitride-based semiconductor crystals will be grown. In that case, as can be seen from FIGS. **2(a)** and **2(b),** there are a layer in which only Ga atoms are arranged and a layer in which only N atoms are arranged in the c-axis direction. Due to such an arrangement of Ga and N atoms, spontaneous electrical polarization is produced in a nitride-based semiconductor. That is why the "c plane" is also called a "polar plane".

As a result, a piezoelectric field is generated in the c-axis direction in the InGaN quantum well of the active layer of a nitride-based semiconductor light-emitting element. Then, some positional deviation occurs in the distributions of electrons and holes in the active layer. Consequently, due to the quantum confinement Stark effect of carriers, the internal quantum efficiency of the active layer decreases, thus increasing the threshold current in a semiconductor laser diode and increasing the power dissipation and decreasing the luminous efficacy in an LED. Meanwhile, as the density of injected carriers increases, the piezoelectric field is screened, thus varying the emission wavelength, too.

As the In mole fraction of the active layer is increased in order to emit light rays falling within long wavelength ranges such as green, orange and red rays, the intensity of the piezoelectric field further increases and the internal quantum efficiency decreases steeply. That is why in an LED that uses a c-plane active layer, the wavelength of a light ray that can be emitted from it is said to be approximately 550 nm at most.

Thus, to overcome such a problem, people proposed that a light-emitting element be fabricated using a substrate, of which the principal surface is an m plane that is a non-polar plane (which will be referred to herein as an "m-plane GaN based substrate"). As shown in FIG. **1,** the m plane of a wurtzite crystal structure is one of six equivalent planes that are parallel to the c-axis and that intersects with the c plane at right angles. For example, an m plane may be a (10-10) plane, which is shadowed in FIG. **1** and which intersects with the [10-10] direction at right angles. The other m planes that are equivalent to the (10-10) plane are (-1010), (1-100), (-1100), (01-10) and (0-110) planes. In this case, "-" attached on the left-hand side of a Miller-Bravais index in the parentheses means a "bar".

FIG. **2(c)** shows the positions of Ga and N atoms in a nitride-based semiconductor crystal in a plane that intersects with the m plane at right angles. Ga atoms and N atoms are on the same atomic plane as shown in FIG. **2 (c),** and therefore, no electrical polarization will be produced perpendicularly to the m plane. That is why if a light-emitting element is fabricated using a semiconductor multilayer structure that has been formed on an m plane, no piezoelectric field will be produced in the active layer, thus overcoming the problem described above.

In addition, since the In mole fraction of the active layer can be increased significantly, LEDs and laser diodes which can emit not only a blue ray but also green, orange, red and other rays with longer wavelengths can be made using the same kind of materials.

Furthermore, as disclosed in Non-Patent Document No. 1, for example, an LED which uses an active layer that has been formed on an m plane will have its polarization property affected by the structure of its valence band. More specifically, the active layer formed on an m plane mainly emits a light ray, of which the electric field intensity is biased toward a direction that is parallel to the a-axis. In the present description, a light ray, of which the electric field intensity is biased toward a particular direction, will be referred to herein as a "polarized light ray". For example, a biased light ray, of which the electric field intensity becomes outstandingly high in a direction parallel to the X-axis, will be referred to herein as a "light ray polarized in the X-axis direction" and a direction that is parallel to the X-axis will be referred to herein as "polarization direction". Also, if when a polarized light ray is incident on an interface, the light ray transmitted through the interface is still a polarized light ray, of which the electric field intensity is still as biased as the incident polarized light ray, then the light ray is regarded herein as "maintaining its polarization property". On the other hand, if the transmitted light ray becomes a polarized light ray, of which the electric field intensity is less biased than the incident polarized light ray, then the light ray is regarded herein as "having had its polarization property lessened". And if the transmitted light ray becomes a polarized light ray, of which the electric field intensity is no longer biased, then the light ray is regarded herein as "having had its polarization property eliminated".

An LED which uses an active layer that has been formed on an m plane (which will be referred to herein as an "m-plane light-emitting element") emits mainly a light ray polarized in the a-axis direction as described above but also emits light rays which are polarized in c- and m-axis directions. However, those light rays that are polarized in the c- and m-axis directions have lower intensities than the light ray polarized in the a-axis direction. That is why in this description, the following discussion will be focused on the light ray polarized in the a-axis direction.

An m-plane light-emitting element has such a polarization property. However, if a light-emitting element with a polarization property is used as a light source, then the quantity of the light reflected at the surface of an object changes, and the object looks different, according to the polarization direction (i.e., the direction in which the LED is arranged), which is a problem. This phenomenon arises because a P-polarized light ray and an S-polarized light ray have mutually different reflectances (specifically, the S-polarized light ray has the higher reflectance). In this description, the "P-polarized light ray" refers herein to a light ray with an electric field component that is parallel to the plane of incidence, while the "S-polarized light ray" refers herein to a light ray with an electric field component that is perpendicular to the plane of incidence. That is why although it is important to increase the degree of polarization of the light emitted from the LED in applications in which the polarization property needs to be used, the polarization property needs to be lessened as much as possible when the light is used for ordinary illumination purposes.

## CITATION LIST

### PATENT LITERATURE

Patent Document No. 1: Japanese Laid-Open Patent Publication No. 2001-308462
Patent Document No. 2: Japanese Laid-Open Patent Publication No. 2003-332697
Patent Document No. 3: Japanese Laid-Open Patent Publication No. 2008-305971
Patent Document No. 4: Japanese Laid-Open Patent Publication No. 2008-109098

### NON-PATENT LITERATURE

Non-Patent Document No. 1: APPLIED PHYSICS LETTERS 92 (2008) 091105
Non-Patent Document No. 2: Thin Solid Films 515 (2008) 768-770

## SUMMARY OF INVENTION

### TECHNICAL PROBLEM

Also, when used as illumination, the LED is required to have high luminance. For that purpose, in making an m-plane light-emitting element, it is important to extract the light emitted from the active layer to an external device with high light extraction efficiency.

Non-Patent Document No. 2 teaches increasing the light extraction efficiency by providing a random micro structure for the light-emitting face of the light-emitting element. If the light that has come from the active layer is incident on the light-emitting face at an angle that is smaller than the angle of total reflection, then the light cannot be extracted to an external device from the light-emitting face. That is why by providing such a random micro structure, the percentage of light rays that are incident on the emitting facet at angles that are larger than the angle of total reflection can be increased, and therefore, the light extraction efficiency can be increased. The random micro structure can not only increase the light extraction efficiency but also change the polarization direction randomly as well. That is why by providing a similar structure for the light-emitting face of an m-plane light-emitting element, an m-plane light-emitting element with no polarization property could be realized.

Non-Patent Document No. 2 teaches forming a random micro structure by a method that uses a self-assembled gold nano-mask (which will be referred to herein as an "SA-Au process"). According to the SA-Au process, a metal thin film is deposited on the light-emitting face and then heated to coagulate the metal thin film and turn it into islands of a sub-micron size. And by performing a dry etching process using the coagulated metal as a hard mask, a random micro structure can be formed. However, according to the SA-Au process, there is an in-plane variation in the process step of heating and coagulating the metal thin film, and therefore, it is difficult to form such a random micro structure with good reproducibility. For that reason, it is difficult to make a light-emitting element with high light extraction efficiency at a good yield by the method disclosed in Non-Patent Document No. 2.

Meanwhile, a method for forming such a random micro structure on the light-emitting face of a semiconductor light-emitting element that uses a c plane as its principal surface (which will be referred to herein as a "c-plane light-emitting element") by performing a wet etching process using crystal anisotropy has also been proposed. However, it is difficult to form such a random micro structure on the light-emitting face of an m-plane light-emitting element by wet etching process. This is because the light-emitting face of an m plane light-emitting element has a different crystal plane from the light-emitting face of a semiconductor light-emitting element that uses a c plane as its principal surface and the anisotropy in the crystal orientation proposed cannot be used.

Patent Document No. 3 discloses a technique for minimizing a decrease in light emission efficiency by providing striped grooves which run perpendicularly to the polarization direction of the light emitted from a light-emitting element, which is made of a semiconductor that uses either a non-polar plane or a semi-polar plane as its principal surface. Meanwhile, Patent Document No. 4 discloses a light-emitting diode device in which an uneven structure that runs perpendicularly to the polarization direction of the light-emitting element is provided for the light-emitting face as in Patent Document No. 3 in order to improve the distribution of the light extracted. According to Patent Document No. 3, the p-wave component of the light incident on the light-emitting face at a Brewster angle can be transmitted through the light-emitting face without being reflected (i.e., at a reflectance of zero). That is why if the plane that defines the striped groove that runs perpendicularly to the polarization direction of the light to extract is used as the light-emitting face, the polarization direction of the light agrees with the direction of the p-wave component, and therefore, the transmittance of the polarized light should be increased, according to Patent Document No. 3. However, the present inventors discovered via experiments that there is very little light to be incident on the light-emitting face at the Brewster angle, and therefore, such an effect of increasing the transmittance of polarized light is very limited.

The present inventors perfected our invention in order to overcome at least one of these problems with the related art, and an object of the present invention is to provide, first and foremost, an m-plane nitride semiconductor light-emitting element that can increase the light extraction efficiency with its polarization property lessened. Another object of the present invention is to provide an m-plane nitride semiconductor light-emitting element that can emit light with the light distribution characteristic improved.

## SOLUTION TO PROBLEM

A semiconductor light-emitting element according to the present invention includes: an n-type nitride semiconductor layer; a p-type nitride semiconductor layer; an active layer region which includes an m-plane nitride semiconductor layer and which is interposed between the n-type nitride semiconductor layer and the p-type nitride semiconductor layer; an n-type electrode which is electrically connected to the n-type nitride semiconductor layer; a p-type electrode which is electrically connected to the p-type nitride semiconductor layer; a light-emitting face, through which polarized light that has been produced in the active layer region is extracted out of this element; and a striped structure which is provided for the light-emitting face and which has a plurality of projections that run in a direction that defines either an angle of 5 degrees to 80 degrees or an angle of -80 degrees to -5 degrees with respect to the a-axis direction of the m-plane nitride semiconductor layer.

Another semiconductor light-emitting element according to the present invention includes: an n-type nitride semiconductor layer; a p-type nitride semiconductor layer; an active layer region which includes an m-plane nitride semiconductor layer and which is interposed between the n-type nitride semiconductor layer and the p-type nitride semiconductor layer; an n-type electrode which is electrically connected to the n-type nitride semiconductor layer; a p-type electrode which is electrically connected to the p-type nitride semiconductor layer; a light-emitting face, through which polarized light that has been produced in the active layer region is extracted out of this element; and a striped structure which is provided for the light-emitting face and which has a plurality of projections that run in a direction that defines either an angle of 30 degrees to 60 degrees or an angle of -60 degrees to -30 degrees with respect to the a-axis direction of the m-plane nitride semiconductor layer.

In one embodiment, the plurality of projections have at least one slope which is not parallel to the light-emitting face.

In one embodiment, the polarized light is produced in the active layer region so as to have a light distribution characteristic, of which the angle of radiation is wider in a c-axis direction than in the a-axis direction.

In one embodiment, the semiconductor light-emitting element further includes an n-type nitride semiconductor substrate which has first and second principal surfaces, the first principal surface is in contact with the n-type nitride semiconductor layer, and the light-emitting face is the second principal surface.

In one embodiment, the p-type nitride semiconductor layer has first and second principal surfaces, the second principal surface is located closer to the active layer region, and the light-emitting face is the first principal surface.

In one embodiment, the semiconductor light-emitting element further includes: an n-type nitride semiconductor substrate which is provided in contact with the n-type nitride semiconductor layer; and a light output member which has first and second principal surfaces. The first principal surface is in contact with the other surface of the n-type nitride semiconductor substrate which is opposite from the surface that contacts with the n-type nitride semiconductor layer. And the light-emitting face is the second principal surface.

In one embodiment, the light output member has a refractive index of greater than one.

In one embodiment, the plurality of projections have a period of 300 nm or more.

In one embodiment, the plurality of projections have a period of 8 μm or less.

A method for fabricating a semiconductor light-emitting element according to the present invention includes the steps of: forming a semiconductor multilayer structure on a substrate, the multilayer structure including an n-type nitride semiconductor layer, a p-type nitride semiconductor layer, and an active layer region which is interposed between the n-type and p-type nitride semiconductor layers and which includes an m-plane nitride semiconductor layer; forming an n-type electrode which is electrically connected to the n-type nitride semiconductor layer and a p-type electrode which is electrically connected to the p-type nitride semiconductor layer; and forming a striped structure, including a plurality of projections that run in a direction that defines either an angle of 5 degrees to 80 degrees or an angle of -80 degrees to -5 degrees with respect to the a-axis direction of the m-plane nitride semiconductor layer, on another surface of the substrate on which the semiconductor multilayer structure has not been formed.

Another method for fabricating a semiconductor light-emitting element according to the present invention includes the steps of: forming a semiconductor multilayer structure on a substrate, the multilayer structure including an n-type nitride semiconductor layer, a p-type nitride semiconductor layer, and an active layer region which is interposed between the n-type and p-type nitride semiconductor layers and which includes an m-plane nitride semiconductor layer; forming an n-type electrode which is electrically connected to the n-type nitride semiconductor layer and a p-type electrode which is electrically connected to the p-type nitride semiconductor layer; and forming a striped structure, including a plurality of projections that run in a direction that defines either an angle of 30 degrees to 60 degrees or an angle of -60 degrees to -30 degrees with respect to the a-axis direction of the m-plane nitride semiconductor layer, on another surface of the substrate on which the semiconductor multilayer structure has not been formed.

**ADVANTAGEOUS EFFECTS OF INVENTION**

In a semiconductor light-emitting element according to the present invention, a striped structure that runs in a direction that defines an angle of either 5 degrees or more or -5 degrees or less with respect to the a-axis is provided for the light-emitting face through which the light emitted from the active layer region is extracted. Thus, polarized light can be incident as a composite wave of p- and s-waves on the slope of projections that form the striped structure. The light that has been incident as such a composite wave of p-and s-waves has its polarization direction changed and is transmitted. Also, the percentage of the p- and s-waves of the light that has been incident on the slope can be varied in a wide range by the striped structure. As a result, the polarization direction is also changed into various directions and the polarization property of the light emitted from the semiconductor light-emitting element can be lessened.

In addition, since the striped structure is oriented in a direction that defines an angle of either 80 degrees or less or -80 degrees or more with respect to the a-axis, most of the light emitted from the active layer region can be made incident on the slope of the striped structure. As a result, the light extraction efficiency can be increased. Furthermore, since the incident light gets refracted at the boundary between the slope of the projections and the outside so as to go closer to the m-axis, the degree of asymmetry of the light distribution characteristic can be improved.

## BRIEF DESCRIPTION OF DRAWINGS

[FIG. 1] FIG. **1 is a** perspective view showing four primitive vectors **a1, a2, a3** and **c** representing a wurtzite crystal structure.

[FIG. 2] FIG. **2(a)** is a perspective view schematically illustrating a unit cell of GaN and **(b)** and **(c)** illustrate the crystal structures of a c plane and an m plane, respectively.

[FIG. 3] FIG. 3 is a schematic cross-sectional view illustrating a first embodiment of a semiconductor light-emitting element according to the present invention.

[FIG. 4] FIG. 4 **(a)** is a perspective view illustrating the striped structure of the first embodiment, **(b)** is a schematic cross-sectional view illustrating a projection of the striped structure, and **(c)** and **(d)** are schematic top views showing the direction in which the stripes run.

[FIG. 5] **FIG. 5(a) through (c)** are schematic cross-sectional views illustrating exemplary projections of the striped structure.

[FIG. 6] FIG. 6(a) and **(b)** are schematic top views illustrating other examples of the striped structure.

[FIG. 7] FIG. 7 shows relations between the angle of incidence, the reflectance and the transmittance of p- and s-waves.

[FIG. 8] FIG. 8(a) schematically shows the propagation vector of light that is polarized in the a-axis direction, and **(b)** shows the light distribution characteristics in the a-and c-axis directions as viewed along the m-axis.

[FIG. 9] FIG. 9 schematically shows an example of polarized light that is incident on a projection of the striped structure when the angle set to be 0 degrees.

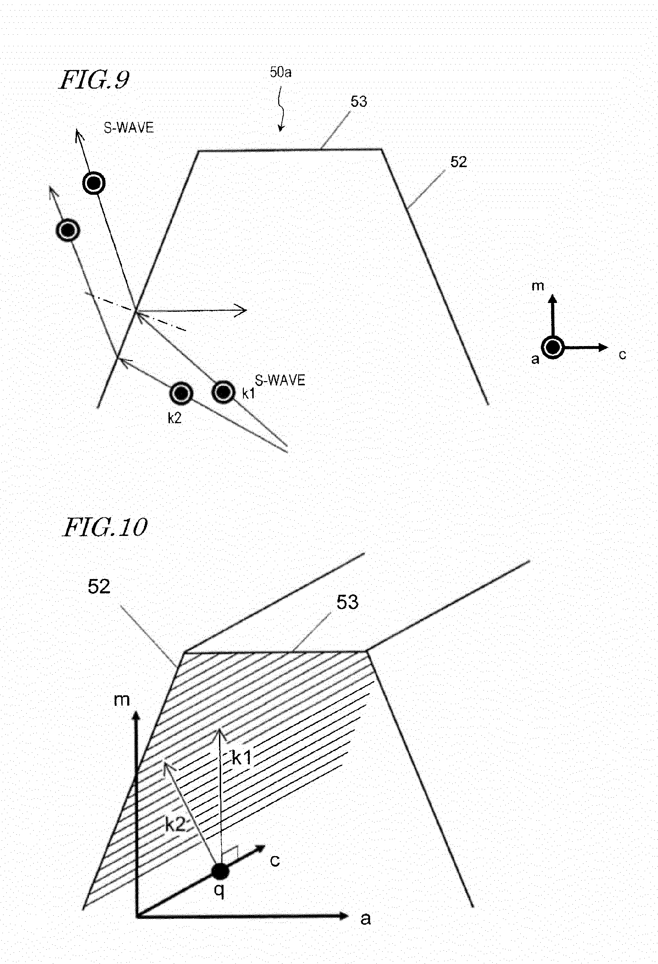

0 [FIG. 10] FIG. **10** schematically shows an example of polarized light that is incident on the light-emitting face of a striped structure, which is formed perpendicularly to the polarization direction.

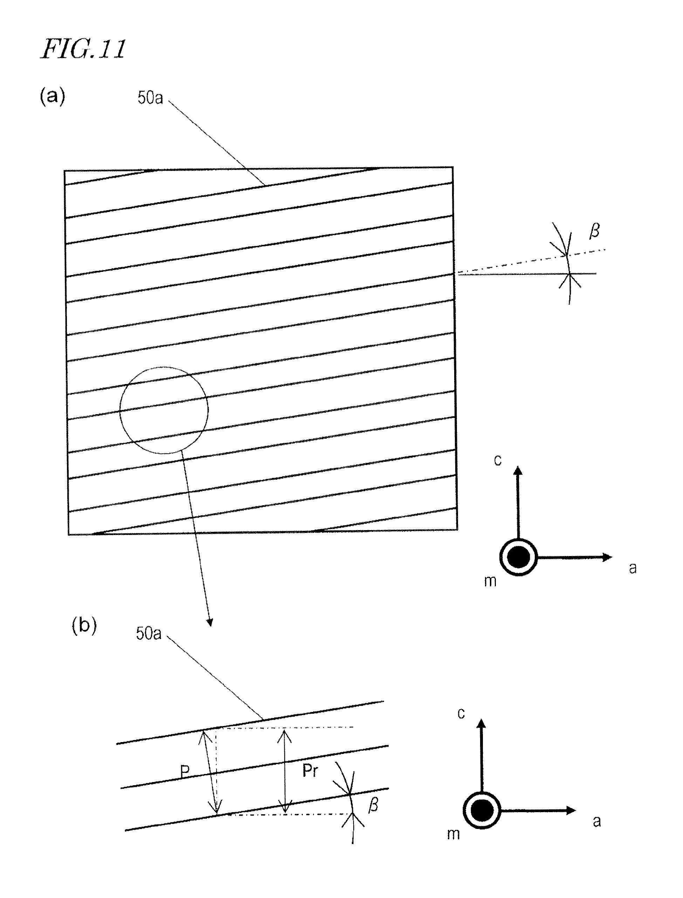

[FIG. 11] FIG. **11(a)** is a top view illustrating a striped structure and **(b)** shows the apparent pitch **Pr** of the striped structure.

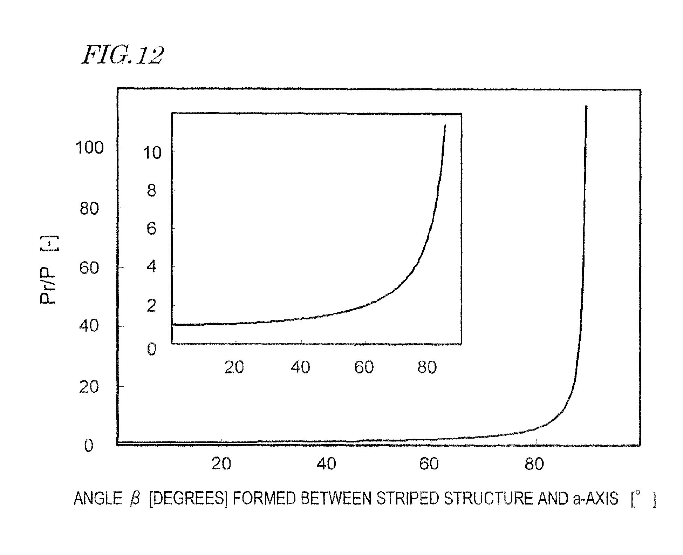

[FIG. 12] FIG. **12 is a** graph showing a relation between the angle β defined by the direction in which the stripes run with respect to the a-axis and the apparent pitch **Pr** and the inserted graph shows, on a larger scale, a range in which the angle β is 85 degrees or less.

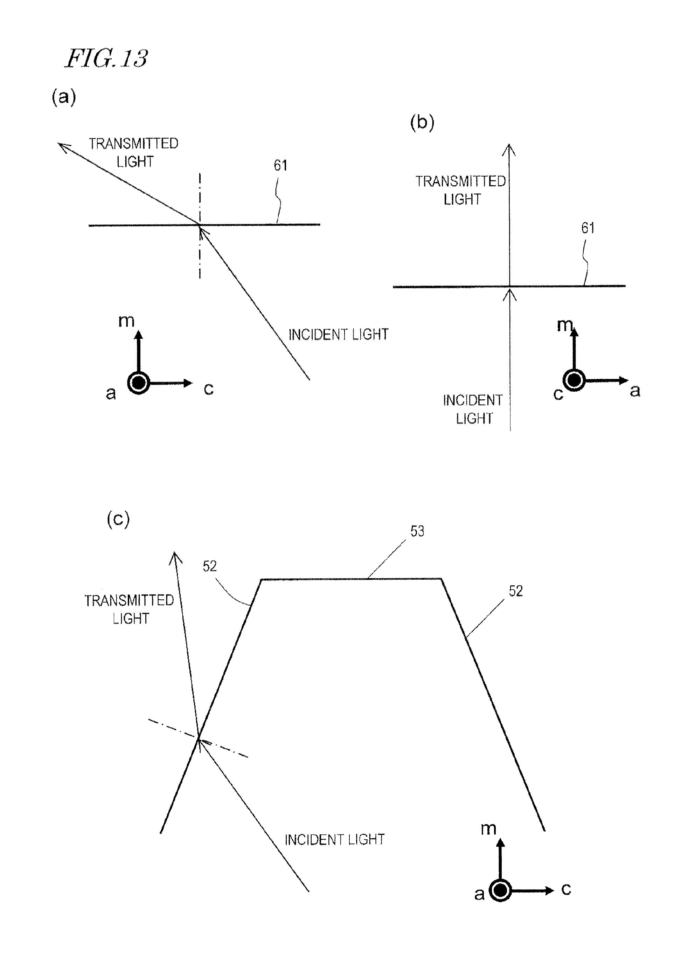

[FIG. 13] FIG. 13(a) and **(b)** schematically show examples of light incident on, and transmitted through, the light-emitting face of a semiconductor light-emitting element having a flat light-emitting face as viewed in the a- and c-axis directions, respectively, and **(c)** schematically shows exemplary light incident on, and transmitted through, the light-emitting face of a nitride-based semiconductor light-emitting element according to the first embodiment.

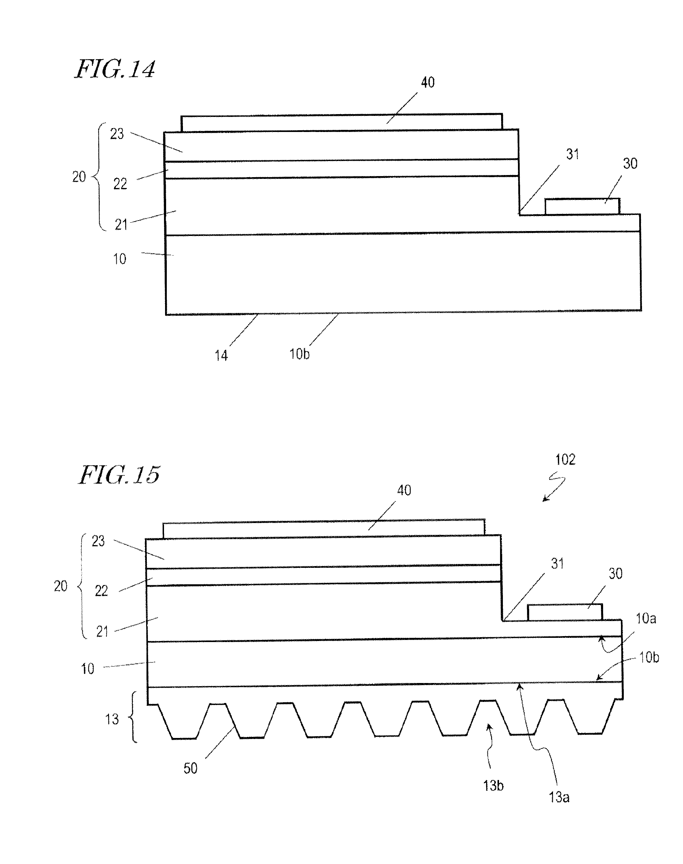

[FIG. **14**] FIG. **14 is a** schematic cross-sectional view illustrating a structure obtained during a manufacturing process of the first embodiment.

[FIG. **15**] FIG. **15 is a** schematic cross-sectional view illustrating a second embodiment of a semiconductor light-emitting element according to the present invention.

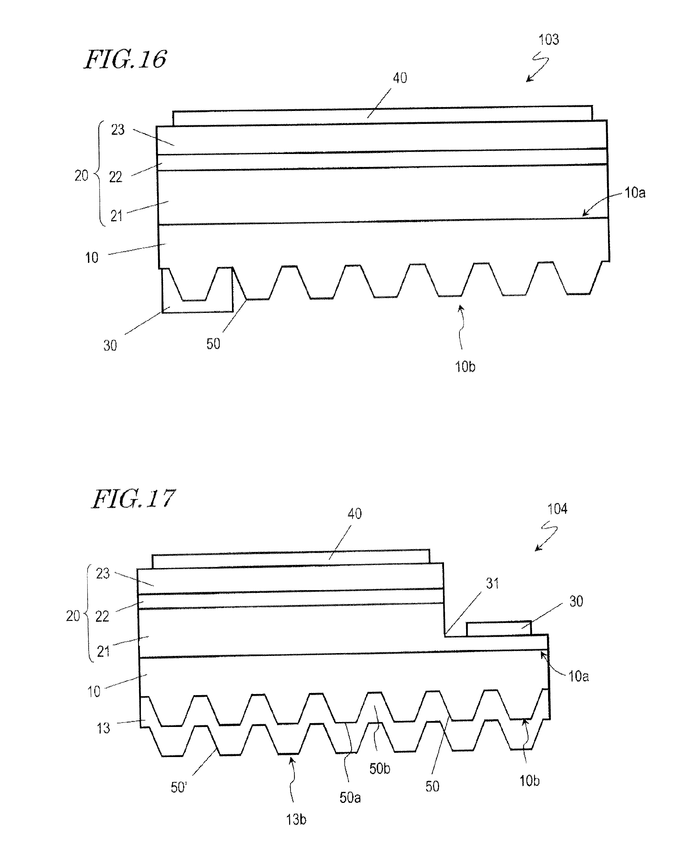

[FIG. **16**] FIG. **16 is a** schematic cross-sectional view illustrating a third embodiment of a semiconductor light-emitting element according to the present invention.

[FIG. **17**] FIG. **17 is a** schematic cross-sectional view illustrating a fourth embodiment of a semiconductor light-emitting element according to the present invention.

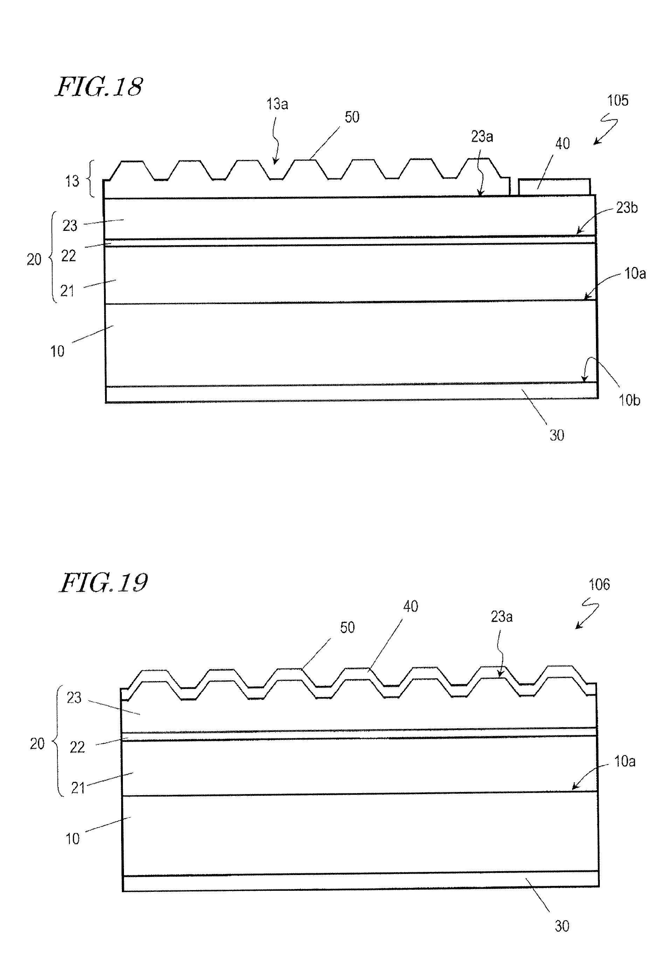

[FIG. **18**] FIG. **18 is a** schematic cross-sectional view illustrating a fifth embodiment of a semiconductor light-emitting element according to the present invention.

[FIG. **19**] FIG. **19** is a schematic cross-sectional view illustrating a sixth embodiment of a semiconductor light-emitting element according to the present invention.

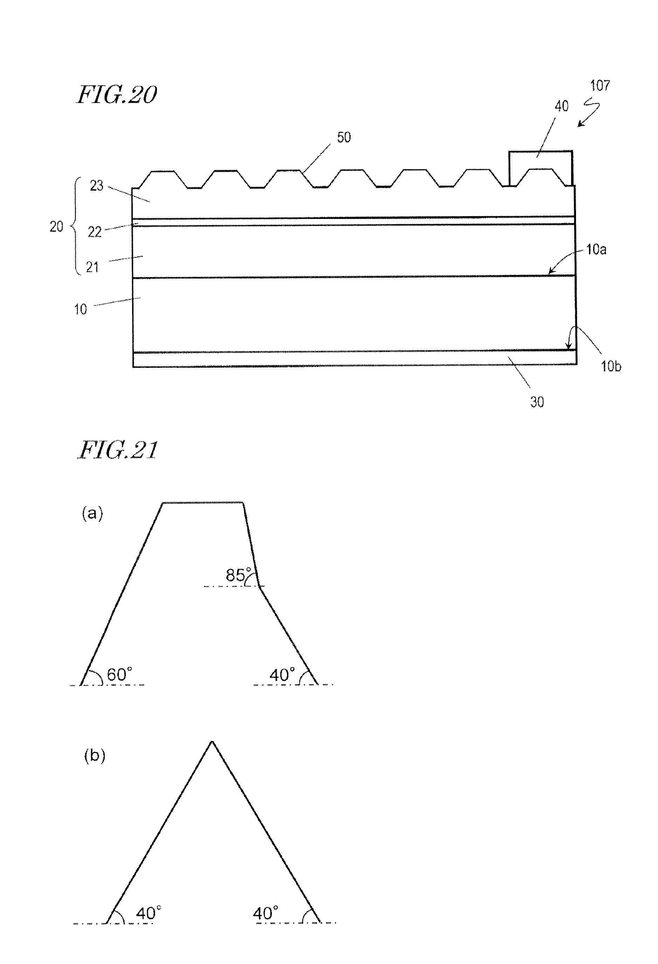

[FIG. **20**] FIG. 20 is a schematic cross-sectional view illustrating a seventh embodiment of a semiconductor light-emitting element according to the present invention.

[FIG. 21] FIG. 21(a) schematically illustrates a cross-sectional shape of the striped structures of Examples 1 and 2, Reference Examples 1 and 2 and Comparative Examples 1 and 2, and (b) schematically illustrates a cross-sectional shape of the striped structures of Example 3 and Reference Example 3.

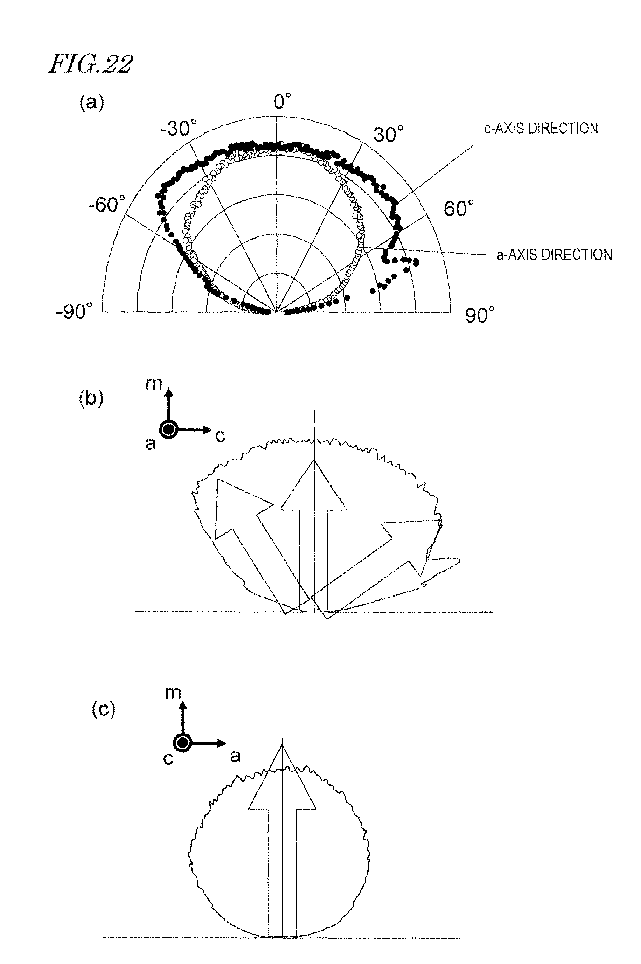

[FIG. 22] FIG. 22(a) shows the light distribution characteristic of a semiconductor light-emitting element having a flat light-emitting face and **(b)** and **(c)** schematically illustrate the results shown in **(a).**

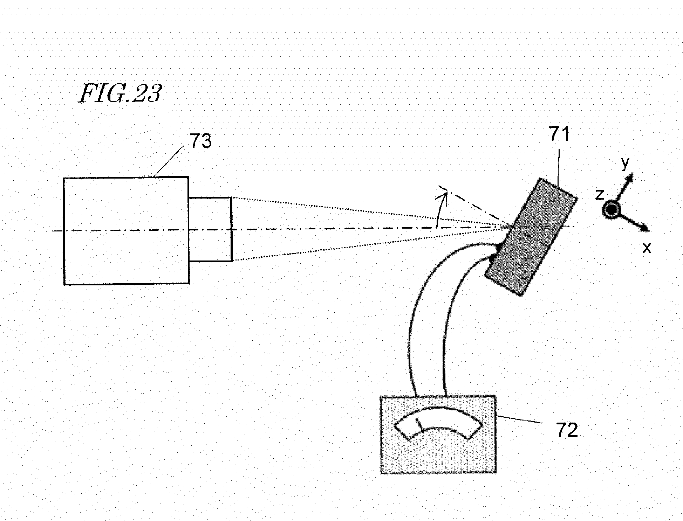

[FIG. 23] FIG. 23 illustrates the arrangement of a measuring system which was used to measure the light distribution characteristic.

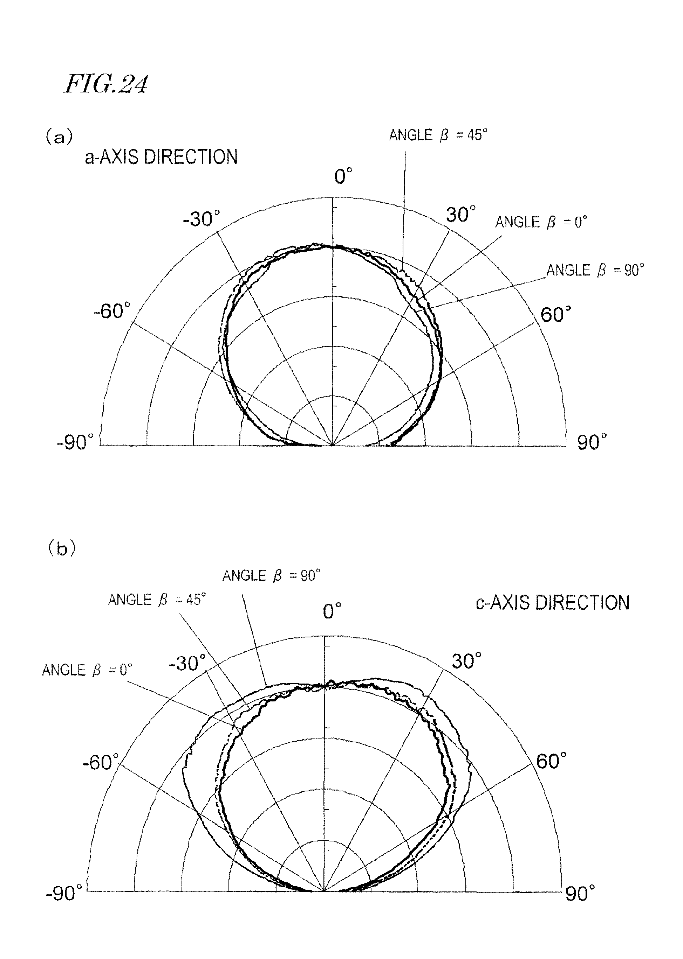

[FIG. **24**] FIG. 24 shows the relation between the orientation of the striped structure and the light distribution characteristic, wherein **(a)** shows the light distribution characteristic in the a-axis direction and **(b)** shows the light distribution characteristic in the c-axis direction.

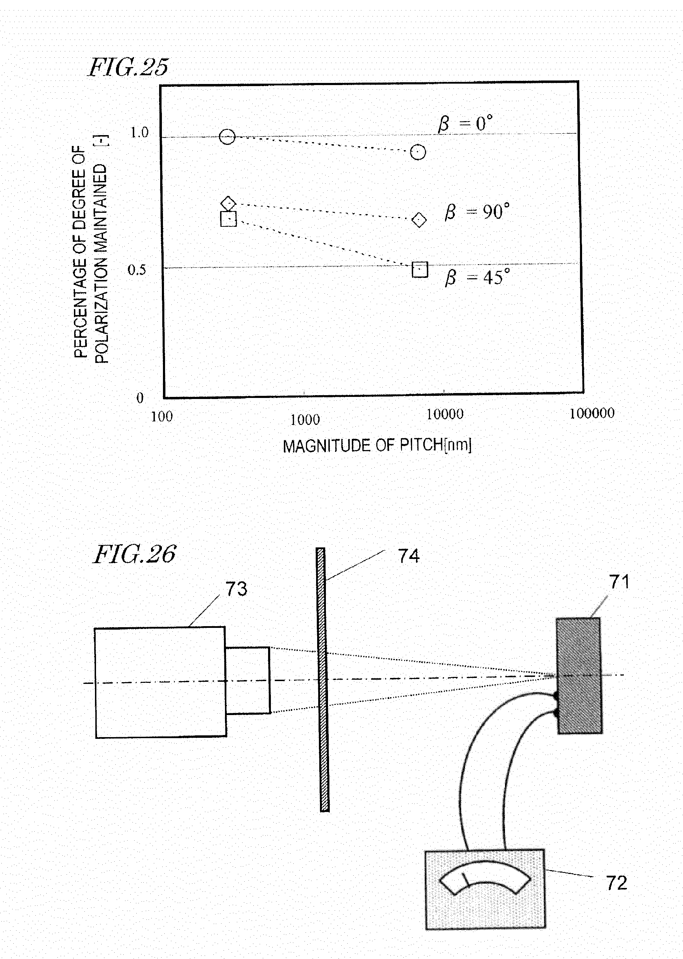

[FIG. **25**] FIG. 25 is a graph showing relations between the pitch of the striped structure of the semiconductor light-emitting elements of Examples 1 and 2, Reference Examples 1 and 2, and Comparative Examples 1 and 2 and the percentage of the degree of polarization maintained.

[FIG. 26] FIG. 26 illustrates the arrangement of a measuring system which was used to measure the degree of polarization.

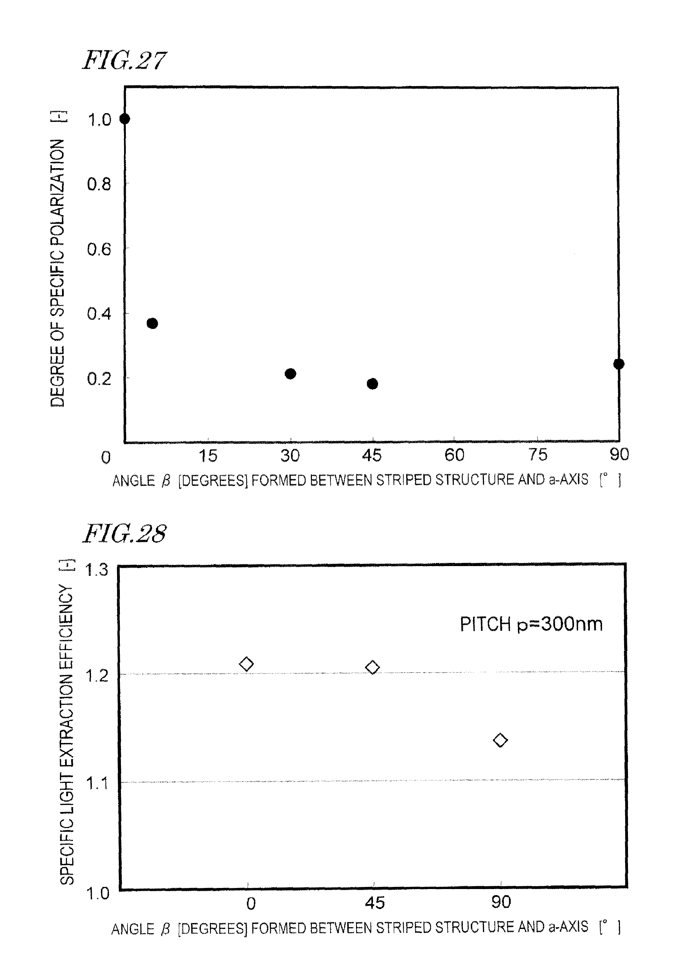

[FIG. 27] FIG. 27 is a graph showing relations between the angles β of the respective striped structures of the semiconductor light-emitting elements of Example 3, Reference Example 3 and comparative example 3 and the degree of specific polarization.

[FIG. 28] FIG. 28 is a graph showing relations between the angles defined by the respective striped structures of the semiconductor light-emitting elements of Example 1, Reference Example 1 and Comparative Example 1 with respect to the a-axis and the light extraction efficiency.

## DESCRIPTION OF EMBODIMENTS

The present inventors carried out an extensive research on the relation between the polarization property and light distribution characteristic of the light emitted from an active layer in an m-plane nitride-based semiconductor light-emitting element and the light-emitting face. As a result, the present inventors discovered that the polarization property of the extracted light should depend on the relation between the direction of the major electric field vector of the polarized light produced in the active layer of the nitride-based semiconductor light-emitting element and the shape of the light-emitting face. The present inventors also discovered that the light distribution characteristic of the light extracted should depend on the relation between the direction of the major propagation vector of the polarized light and the shape of the light-emitting face. And based on these discoveries, the present inventors invented a nitride-based semiconductor light-emitting element that could increase the efficiency to extract the light while lessening its polarization property and that could improve its light distribution characteristic at the same time by optimizing the shape of the light-emitting face. Hereinafter, embodiments of a light-emitting element according to the present invention will be described with reference to the accompanying drawings. In the following description, any pair of components shown in multiple drawings and having substantially the same function will be identified by the same reference numeral for the sake of simplicity. It should be noted that the present invention is in no way limited to the embodiments to be described below.

(EMBODIMENT 1)

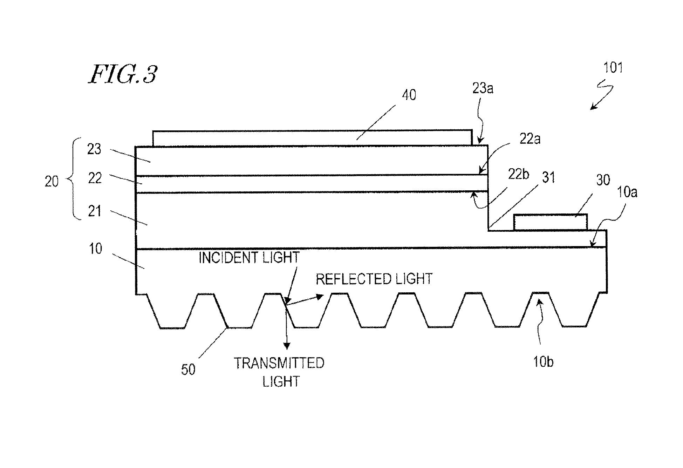

FIG. 3 schematically illustrates a cross-sectional structure of a semiconductor light-emitting element according to a first embodiment of the present invention. As shown in FIG. 3, the semiconductor light-emitting element 101 includes a substrate 10 and a semiconductor multilayer structure 20 which has been formed on the substrate 10 and which includes an active layer region 22. As will be described in detail later, this semiconductor light-emitting element 101 emits polarized light that has been produced highly efficiently in an active layer, of which the principal surface is an m plane of a nitride-based semiconductor, with the polarization property lessened on the light-emitting face. Thus, this semiconductor multilayer structure 20 includes an active layer region 22, of which the principal surface is an m plane, and is made of a nitride semiconductor, more specifically, an $Al_xIn_yGa_zN$ (where $x + y + z = 1$, $x \geq 0$, $y \geq 0$ and $z \geq 0$) semiconductor.

The semiconductor multilayer structure 20 includes not only the active layer region 22 but also an n-type nitride semiconductor layer 21 and a p-type nitride semiconductor layer 23. And the active layer region 22 is interposed between the n-type nitride semiconductor layer 21 and the p-type nitride semiconductor layer 23. Although not shown in FIG. 3, an undoped GaN layer may be further provided between the active layer region 22 and the p-type nitride semiconductor layer 23.

The semiconductor light-emitting element 101 further includes an n-type electrode 30 and a p-type electrode 40, which are electrically connected to the n-type nitride semiconductor layer 21 and the p-type nitride semiconductor layer 23, respectively. In this embodiment, by making a recess 31 in the semiconductor multilayer structure 20, the n-type nitride semiconductor layer 21 is partially exposed and the n-type electrode 30 is arranged on that exposed part of the n-type nitride semiconductor layer 21. The n-type electrode 30 may be a stack (Ti/Pt) of Ti and Pt layers, for example. Meanwhile, the p-type electrode 40 is arranged on the p-type nitride semiconductor layer 23. The p-type electrode 40 suitably covers almost the entire surface of the p-type nitride semiconductor layer 23. The p-type electrode 40 may be a stack (Pd/Pt) of Pd and Pt layers, for example.

As for the substrate 10, a member on which the semiconductor multilayer structure 20 can be formed suitably is selected. Specifically, the substrate 10 does not have to be a GaN substrate but may also be a gallium oxide substrate, an SiC substrate, an Si substrate or a sapphire substrate, for example. To grow epitaxially the semiconductor multilayer structure 20 including the active layer region, of which the principal surface is an m-plane, on the substrate 10, the plane orientation of the SiC or sapphire substrate is suitably an m plane, too. However, it was reported that a-plane GaN could grow on an r-plane sapphire substrate. That is why to grow the active layer region 22, of which the principal surface is an m plane, the surface of the substrate **10** does not have to be an m plane. Optionally, after the semiconductor multilayer structure **20** has been formed on another substrate, instead of this substrate **10,** the semiconductor multilayer structure **20** may be removed from that another substrate and transferred onto this substrate **10.**

The n-type nitride semiconductor layer **21** may be made of n-type $Al_uGa_vIn_wN$ (where u + v + w = 1, u $\geq$ 0, v $\geq$ 0 and w $\geq$ 0), for example. As the n-type dopant, silicon (Si) may be used, for example.

The p-type nitride semiconductor layer **23** may be made of a p-type $Al_sGa_tN$ (where s + t = 1, s $\geq$ 0 and t $\geq$ 0) semiconductor, for example. As the p-type dopant, magnesium (Mg) may be used, for example. Examples of other p-type dopants include zinc (Zn) and beryllium (Be). In the p-type nitride semiconductor layer **23,** the mole fraction s of Al may be either constant in the thickness direction or vary continuously or stepwise in the thickness direction. Specifically, the p-type nitride semiconductor layer **23** may have a thickness of approximately 0.2 $\mu$m to 2 $\mu$m.

In the p-type nitride semiconductor layer **23,** in the vicinity of the first principal surface **23a** (i.e., in the vicinity of the interface with the p-type electrode **40),** the mole fraction **s** of Al is suitably equal to zero, i.e., the p-type nitride semiconductor layer **23** is suitably made of GaN there. In that case, the GaN portion is heavily doped with a p-type dopant and suitably functions as a contact layer. Although not shown in FIG. **3,** a contact layer of $p^+$-GaN may be provided between the p-type nitride semiconductor layer **23** and the p-type electrode **40.**

The active layer region **22** is the light-emitting region of this semiconductor light-emitting element 101 and includes a nitride semiconductor layer which has been formed on an m plane in order to emit polarized light with high luminous efficacy. The light emitted in the active layer region **22** becomes light that is polarized in the a-axis direction. The growing direction of this active layer region **22** is perpendicular to an m plane and the first and second principal surfaces **22a** and **22b** of the active layer region are both m planes. However, the first and second principal surfaces **22a** and **22b** do not have to be perfectly parallel to the m plane but may define a predetermined tilt angle with respect to the m plane. Specifically, the tilt angle is defined to be the angle formed between a normal to the first or second principal surface **22a** or **22b** and a normal to the m plane. The absolute value of the tilt angle $\theta$ may be 5 degrees or less, and is suitably 1 degree or less, in both the c- and a-axis directions. If the tilt angle falls within such a range, the first or second principal surface **22a** or **22b** of the active layer region is tilted overall with respect to the m plane but should be made up of a plurality of steps, each of which is as high as one to a few atomic layers, and should include a lot of m-plane regions, speaking microscopically. That is why a plane that defines a tilt angle of 5 degrees or less (in absolute value) with respect to the m plane should have the same property as the m plane. Thus, the m-plane nitride semiconductor layer of this embodiment includes a nitride semiconductor layer that has been formed on a surface which defines a tilt angle of 5 degrees or less (in absolute value) with respect to an m plane. If the absolute value of the tilt angle $\theta$ were greater than 5 degrees, then the internal quantum efficiency would decrease due to a piezoelectric field. For that reason, the absolute value of the tilt angle $\theta$ is set to be 5 degrees or less.

The active layer region **22** has a GaInN/GaN multiple quantum well (MQW) structure in which $Ga_{1-x}In_xN$ well layers (where 0 < x < 1), each of which is an m-plane nitride semiconductor layer with a thickness of approximately 3 nm to 20 nm, and GaN barrier layers, each having a thickness of approximately 5 nm to 30 nm, are stacked alternately. The wavelength of the light emitted from the semiconductor light-emitting element **101** is determined by the magnitude of the band gap of the semiconductor that forms the active layer region **22,** more specifically, the In mole fraction x of the composition $Ga_{1-x}In_xN$ of the semiconductor that forms the well layers. No piezoelectric field is generated in the active layer region **22** that has been formed on an m plane. That is why even if the In mole fraction is increased, decrease in luminous efficacy can be minimized. As a result, by increasing the In mole fraction significantly, even a semiconductor light-emitting element that uses a nitride-based semiconductor also realizes a red-ray-emitting light-emitting diode.

The substrate **10** has first and second principal surfaces **10a** and **10b,** and the first principal surface **10a** is in contact with the n-type nitride semiconductor layer **21** of the semiconductor multilayer structure **20.** The second principal surface **10b** becomes a light-emitting face, through which the polarized light emitted from the active layer region **22** is extracted. In this embodiment, the second principal surface **10b** has a striped structure **50** in order to extract light with the polarization property lessened. Hereinafter, the striped structure **50** will be described in detail.

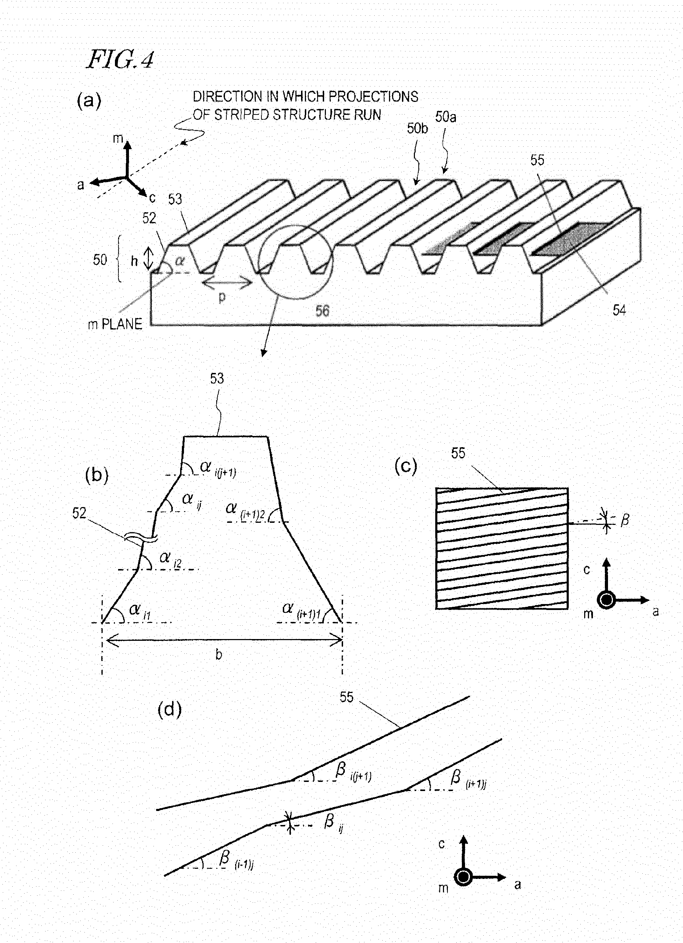

FIG. **4(a)** is a perspective view schematically illustrating the striped structure **50.** At the upper left corner of FIG. **4(a),** shown are the crystal axis directions of the m-plane nitride semiconductor layers included in the active layer region **22** and the direction in which the projections (raised portions or ridges) **50a** of the striped structure run. As shown in FIG. **4(a),** the striped structure **50** has a plurality of projections **50a** which run in a direction that defines an angle of 5 to 80 degrees with respect to the a-axis of the m-plane nitride semiconductor layers. The second principal surface **10b** with this striped structure **50,** i.e., the light-emitting face, is parallel to the a- and c-axes and intersects with the m-axis at right angles. Alternatively, the striped structure **50** may include a plurality of projections **50a** which run in a direction that defines an angle of -80 degrees to -5 degrees with respect to the a-axis of the m-plane nitride semiconductor layer. Suitably, the direction in which the projections **50a** run defines either an angle of 30 degrees to 60 degrees or an angle of -60 degrees to -30 degrees with respect to the a-axis of the m-plane nitride semiconductor layer. More suitably, the direction in which the projections **50a** run defines either an angle of 40 degrees to 50 degrees or an angle of -50 degrees to -40 degrees with respect to the a-axis of the m-plane nitride semiconductor layer.

As a plurality of grooves **50b** runs in a direction that defines either an angle of 5 degrees to 80 degrees or an angle of -80 degrees to -5 degrees with respect to the a-axis between those projections **50a,** it can also be said that this striped structure **50** has these grooves **50b.** In this description, however, in order to discuss the polarized light to be extracted through a member with this striped structure **50,** the striped structure **50** is regarded herein as having those "projections". However, those "projections" may be formed in the striped structure **50** by making those "grooves" in the light-emitting face.

In this embodiment, each projection **50a** has an upper surface **53** which is parallel to the second principal surface **10b** that is the light-emitting face and at least one slope **52** which is not parallel to the light-emitting face. However, each projection **50a** has only to have at least one slope **52** which is not parallel to the second principal surface **10b.** Also, as will be described later, the slope **52** may also be curved. The height **h** of each projection **50a** is suitably equal to or greater than $\lambda / (4 \times n)$ and more suitably falls within the range of $\lambda / (4 \times n)$ to 10 $\mu$m, where $\lambda$ is the emission wavelength of the active layer region **22** and n is the refractive index of the material of the striped structure **50.** In this embodiment, n is the refractive index of the material of the substrate **10.** For example, supposing the polarized light produced in the active layer region **22** has a wavelength of 450 nm and the material of the striped structure **50** has a refractive index **n** of 2.5, the height **h** is suitably equal to or greater than 45 nm.

By setting the height **h** to be equal to or greater than $\lambda/(4 \times n)$, the striped structure **50** can increase the light extraction efficiency. The upper limit of the height **h** depends on the manufacturing method adopted. For example, if a chemical dry etching process is adopted, the slope of the striped structure is likely to produce crystal planes which form $\alpha$ = approximately 65 degrees, and therefore, the striped structure comes to have an aspect ratio of approximately 1.2. In this example, the aspect ratio is represented as the ratio of the height **h** of the striped structure **50** to the length **b** of the bottom of the striped structure **50** as given by the following Equation (1):

$$\text{aspect ratio = height } \mathbf{h} \text{ / bottom length } \mathbf{b} \qquad (1)$$

In this case, if the bottom length **b** is 10 $\mu$m, then the upper limit of the height **h** becomes 12 $\mu$m. In this description, the chemical dry etching process means a dry etching process to be carried out under plasma which is highly chemically reactive to a nitride semiconductor (such as chlorine radicals).

On the other hand, if a physical dry etching process is adopted, then the aspect ratio of the striped structure can be increased to approximately 5. In that case, if the bottom length **b** is 10 $\mu$m, then the height **h** becomes 50 $\mu$m. In this description, the physical dry etching process means a dry etching process to be performed physically on a nitride semiconductor under plasma (such as chlorine ions).

Actually, however, the height **h** cannot be equal to or greater than the thickness of the substrate. Also, the height **h** is suitably set to be approximately equal to or smaller than a half of the thickness of the substrate. Then, even after the striped structure has been formed, the substrate can maintain its rigidity and can be handled with no problem at all.

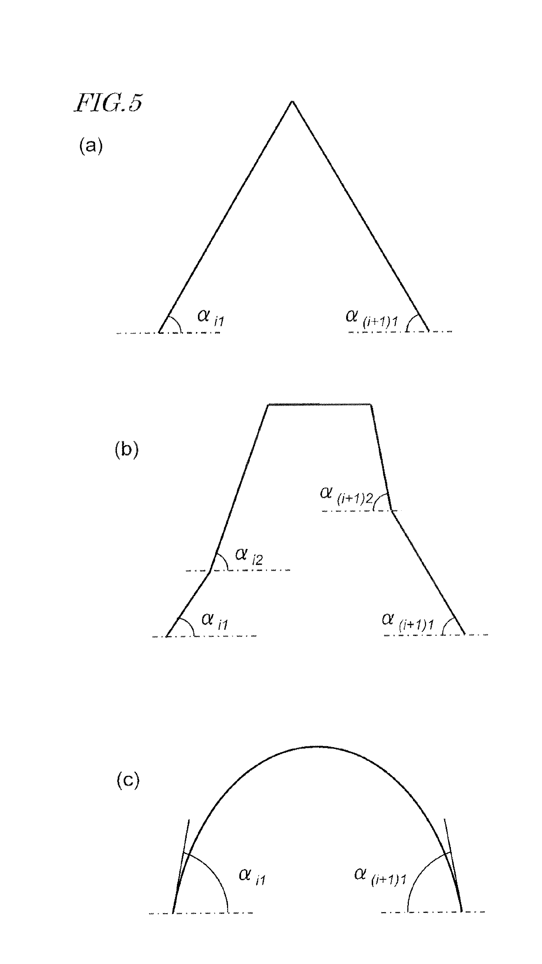

FIG. **4(b)** generally illustrates a cross-sectional structure **56** of a single projection **50a** of the striped structure **50** as viewed perpendicularly to the longitudinal direction (i.e., perpendicularly to the direction in which the projection **50a** runs). As shown in FIG. **4(b),** the slope **52** may have a plurality of slope portions. If the angle defined by each of those slope portions with respect to the m plane is $\alpha_{ij}$ (where i and j are integers and satisfy $0 \leq i, j \leq \infty$), then $\alpha_{ij} \neq \alpha_{lm}$ (where $i \neq 1$ or $j \neq m$ and $0 \leq l, m \leq i, j$) may be satisfied. $\alpha_{ij}$ is the angle formed between the $j^{th}$ slope portion as counted from the root of the projection **50a** and the m plane (which is either the light-emitting face or the second principal surface) in the $i^{th}$ one of the slopes **52** that are arranged perpendicularly to the longitudinal direction of the projection **50a.** Optionally, a single projection **50a** may have multiple different cross-sectional shapes **56** in its longitudinal direction. Examples of such cross-sectional shapes **56** include a triangular shape such as the one shown in FIG. **5(a)** and a horizontally asymmetric shape such as the one shown in FIG. **5(b).** Also, if $j = \infty$ (i.e., if the slope **52** is made up of a lot of very small sloped portions with different $\alpha_{ij}$), then the cross-sectional shape **56** will be a partially curved shape including a portion of a circle or an ellipse as shown in FIG. **5(c).** Furthermore, the projections **50a** that form the striped structure **50** do not have to be arranged at regular intervals but may have their pitch **p** modulated. Even so, the effects of this application can also be achieved. Moreover, not every projection **50a** has to have the same height **h** but some projections **50a** may have mutually different heights.

FIG. **4(c)** is a schematic top view of the striped structure **50.** As described above, the angle $\beta$ defined by the direction in which the projections **50a** of the striped structure **50** run with respect to the a-axis (which will be simply referred to herein as an "angle $\beta$") falls suitably within the range of 5 degrees $\leq |\beta| \leq$ 80 degrees, more suitably within the range of 30 degrees $\leq |\beta| \leq$ 60 degrees, and even more suitably within the range of 40 degrees $\leq |\beta| \leq$ 50 degrees. In this case, the angle $\beta$ is supposed to be the angle defined by the line of intersection **55** between the shadowed plane **54** shown in FIG. **4(a)** and the slope **52** with respect to the a-axis and $|\beta|$ is the absolute value of the angle $\beta$. That is to say, 5 degrees $\leq |\beta| \leq$ 80 degrees means that the angle $\beta$ falls either within the range of 5 degrees to 80 degrees or within the range of -80 degrees to -5 degrees. Also, if the angle falls within any of these ranges, significant effects of the present invention can be achieved as will be described later with respect to specific examples of the present invention.

The plane **54** is parallel to a plane defined by the a- and c-axes (which will be referred to herein as an "ac plane") and is present where the plane **54** intersects with the slope **52**. FIG. **4(d)** is an enlarged view illustrating a portion of FIG. **4(c)** on a larger scale. As shown in FIG. **4(d)**, the line **55** does not have to be a single straight line but may also be made up of a plurality of line segments which define mutually different angles with respect to the a-axis. In this case, if the angle defined by each of those line segments of the line **55** with respect to the a-axis is supposed to be $\beta_{ij}$ (where i and j are integers and satisfy $0 \leq i, j \leq \infty$) as shown in FIG. **4(d),** then $\beta_{ij} \neq \beta_{lm}$ (where $i \neq l$ or $j \neq m$ and $0 \leq l, m \leq i, j$) may be satisfied. However, 5 degrees $\leq |\beta_{ij}| \leq 80$ degrees, more suitably 30 degrees $\leq |\beta_{ij}| \leq 60$ degrees, needs to be satisfied.

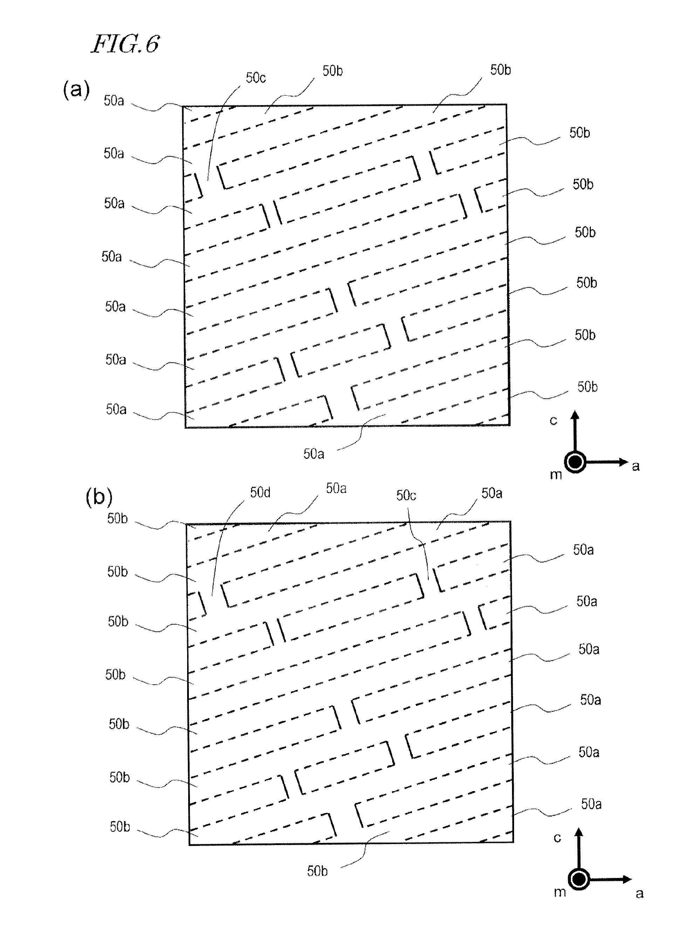

Also, as shown in FIG. **6(a),** in the striped structure **50**, a pair of adjacent projections **50a** may be connected together with at least one connecting portion **50c** that does not run parallel to the direction in which the projections **50a** run. Alternatively, as shown in FIG. **6(b),** in the striped structure **50,** each of the projections **50a** may be divided by at least one groove **50d** which does not run parallel to the projection **50a** into the portions indicated by dashed lines. In these cases, the projections **50a** as indicated by the dashed lines are suitably longer than the connecting portions **50c** or the grooves **50d** as indicated by the solid lines.

Hereinafter, the relationship between the striped structure **50** and the polarization property of the light emitted from this semiconductor light-emitting element **101,** the relationship between the striped structure **50** and the light extraction efficiency and the relationship between the striped structure **50** and the light distribution characteristic will be explained.

As shown in FIG. **3,** the polarized light produced in the active layer region **22** travels through the n-type nitride semiconductor layer **21** and the substrate **10** and then is incident on the second principal surface **10b** that is a light-emitting face (such light will be referred to herein as "incident light"). Part of the incident light is transmitted through the constituent material of the striped structure **50** and travels outside of this light-emitting element **100.** Meanwhile, another part of the incident light is reflected at the second principal surface **10b** and then travels inside the constituent material of the striped structure **50** again. In the following description, the light that has gone out of this light-emitting element through the constituent material of the striped structure **50** will be referred to herein as "transmitted light" and the light that travels inside the constituent material of the striped structure **50** again will be referred to herein as "reflected light". Also, the ratio of the intensity of the transmitted light to that of the incident light will be referred to herein as "transmittance" and the ratio of the intensity of the reflected light to that of the incident light will be referred to herein as "reflectance". Furthermore, the angle formed between the propagation vector of the incident light and a vector representing a normal to the light-emitting face (i.e., the second principal surface **10b)** will be referred to herein as the "angle of incidence". The angle formed between the propagation vector of the transmitted light and a vector representing a normal to the light-emitting face will be referred to herein as the "angle of refraction". And a plane defined by the propagation vector of the incident light and the vector representing a normal to the light-emitting face will be referred to herein as an "incident plane". In this case, the propagation vector can also be regarded as representing the direction in which light travels. Furthermore, light is decomposed into two electric field vector components that are respectively parallel and perpendicular to the incident plane, which will be referred to herein as a "p-wave" and an "s-wave", respectively.

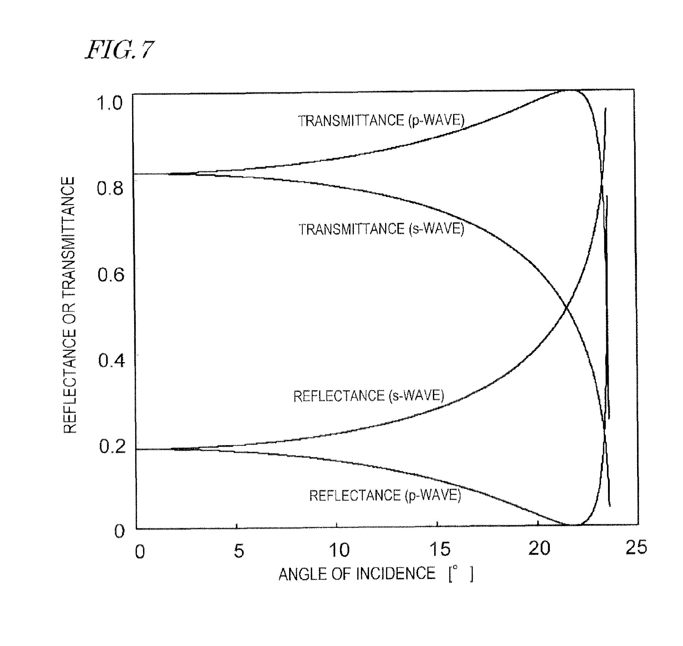

Next, it will be considered on what condition the polarization property of the light that has been incident on a plane can be maintained in the transmitted light, too. FIG. **7** shows how the transmittance and reflectance changed with the angle of incidence of the light that was incident on a plane. The results shown in FIG. **7** were separately calculated for the p-wave and s-wave components. The calculations were made based on Fresnel equations represented by the following Equations (2) to (5), where Rp denotes the reflectance of the p-wave, Rs denotes the reflectance of the s-wave, Tp denotes the transmittance of the p-wave, Ts denotes the transmittance of the s-wave, $\theta i$ denotes the angle of incidence, and $\theta t$ denotes the angle of refraction. The calculations were made with the refractive index **n** of the constituent material of the striped structure **50** supposed to be 2.5 and the refractive index outside of the constituent material of the striped structure **50** supposed to be 1.0.

As can be seen from FIG. **7,** the p- and s-wave components of the incident light have mutually different transmittances and reflectances. This means that if the incident light is a composite wave of the p- and s-waves, the ratio of the scalar quantity of the electric field vector of the p-wave of the incident light to that of the electric field vector of the s-wave changes when the light is transmitted through a plane (i.e., the polarization direction of the transmitted light has changed from that of the incident light).

However, if either the p-wave component or the s-wave component of the incident light is equal to zero, such a zero wave component cannot be included in the transmitted light, and therefore, the ratio of the scalar quantities does not change and the electric field vector direction can be maintained. In other words, in order to lessen the polarization property, the light incident on the surface of the striped structure **50** that contacts with the outside may not consist of only the p-wave component or only the s-wave component.

$$R_p = \left\{ \frac{\tan(\theta_i - \theta_t)}{\tan(\theta_i + \theta_t)} \right\}^2 \tag{2}$$

$$R_p = \left\{ \frac{\sin(\theta_i - \theta_t)}{\sin(\theta_i + \theta_t)} \right\}^2 \tag{3}$$

$$T_p = \frac{n_t \cos\theta_t}{n_i \cos\theta_i} \left\{ \frac{2\sin\theta_t \cos\theta_t}{\sin(\theta_i + \theta_t)\cos(\theta_i - \theta_t)} \right\}^2 \tag{4}$$

$$T_p = \frac{n_t \cos\theta_t}{n_i \cos\theta_i} \left\{ \frac{2\sin\theta_t \cos\theta_t}{\sin(\theta_i + \theta_t)} \right\}^2 \tag{5}$$

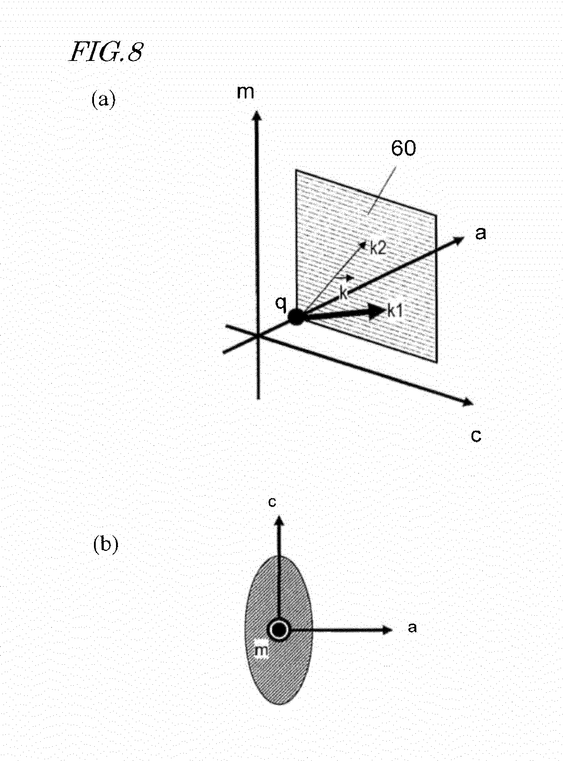

The semiconductor light-emitting element **101** made of a nitride-based semiconductor that uses an m plane as its principal surface produces light polarized in the a-axis direction. FIG. **8(a)** schematically illustrates a range in which most of the propagation vector of the light polarized in the a-axis direction falls. This propagation vector is mostly made up of components that are perpendicular to the electric field vector. In this case, most of the propagation vectors **k1, k2,** and so on of the light polarized in the a-axis direction, which has been produced at the point **q,** are included within the shadowed plane **60** shown in FIG. **8(a)**, i.e., a plane which is parallel to the plane defined by the m-and c-axes (which will be referred to herein as an "mc plane"). FIG. **8(b)** shows the light distribution characteristic of the polarized light that has been produced at the point **q.** If the point **q** is put at the origin of the acm coordinate system, the polarized light has such light distribution characteristic that the angle of radiation is wider in the c-axis direction (i.e., on the mc plane) rather than in the a-axis direction (i.e., on the ma plane) as described above. Due to such a light distribution characteristic, when the striped structure **50** is formed on the light-emitting face, the polarization property of the transmitted light depends on the angle $\beta$ defined by the striped structure **50** with respect to the a-axis.

As shown in FIG. **9**, in the semiconductor light-emitting element with a structure in which the stripes run parallel to the a-axis (i.e., $\beta$ = 0 degrees), the light incident on the slope **52** and upper surface **53** of the striped structure **50** is polarized in the a-axis direction, and therefore, consists mostly of s-waves. The electric field intensity distribution of the polarized light is biased toward the a-axis direction and is very little in the direction that is perpendicular to the a-axis direction. Consequently, the p-wave component of the light incident on the slope **52** and the upper surface **53** is almost equal to zero. Thus, for the reasons described above, if $\beta$ = 0 degrees, the polarization property of the transmitted light is substantially maintained.

If the angle $\beta$ is greater than 0 degrees (i.e., if the direction in which the stripes run becomes not parallel to the a-axis), then the slope **52** becomes not parallel to the a-axis. As a result, the light incident on the slope **52** comes to have a p-wave component, and the polarization property is lessened for the reasons described above. The same can be said if the angle $\beta$ has a negative value.

The polarization property can also be lessened even if the angle $\beta$ is 90 degrees. When the angle $\beta$ is 90 degrees, the stripes run in the c-axis direction as shown in FIG. **10**. In that case, the propagation vectors of the light polarized in the a-axis direction, which has been produced at the point **q,** are present within the mc plane such as k1 and k2 as shown in FIG. **10**. In such a situation, if the angle defined by the propagation vector **k1** with respect to the c-axis is 90 degrees, then the incident plane of the propagation vector **k1** becomes parallel to the ma plane. Since the electric field vector direction is the a-axis direction, the polarized light **k1** defined by the propagation vector **k1** is incident as a p-wave on the slope **52** of the striped structure **50**. Meanwhile, there is no s-wave component there. Consequently, the electric field vector direction of the polarized light **k1** is maintained.

However, in most of the light polarized in the a-axis direction, which has been produced at the point **q,** the angle defined by the propagation vector with respect to the c-axis becomes different from 90 degrees as in the propagation vector **k2.** The incident plane of the propagation vector **k2** is not parallel to the ma plane. In that case, the polarized light **k2** with the propagation vector **k2** is incident as a composite wave of s- and p-waves on the slope **52** of the striped structure **50.** That is why when the polarized light **k2** is transmitted through the slope **52** to leave this light-emitting element, the ratio of the scalar quantities of the p-and s-waves changes and the electric field vector direction changes, too. As a result, every light polarized in the a-axis direction, which has been produced at the point **q,** has its electric field vector direction disturbed at the slope **52** except the polarized light k1. Consequently, if $\beta$ = 90 degrees, the degree of polarization can be reduced. In this description, the "degree of polarization" is a value calculated by the following Equation (6):

$$(degree\ of\ polarization)\ =\ (I_{max}\ -\ I_{min})\ /\ (I_{max}\ +\ I_{min})\quad(6)$$

$I_{max}$ and $I_{min}$ are values to be obtained when measurement is carried out in the following manner. Specifically, a polarizer is arranged parallel to the light-emitting face and the intensity of the light that has been transmitted through the polarizer is measured with the polarizer rotated. The intensity of the light measured becomes a maximum value at a certain angle and becomes a minimum value at another angle. The maximum and minimum values in such a situation are identified herein by $I_{max}$ and $I_{min}$, respectively. If the intensity of the light remains the same at every angle, then $I_{max}$ and $I_{min}$ are equal to each other and the degree of polarization becomes zero.

As described above, the degree to which the polarization property is lessened depends on the angle $\beta$. It can also be seen that the polarization property is maintained only in a special situation where $\beta$ = 0. As will be described later for specific examples of the present invention, the degree to which the polarization property is lessened can be evaluated by the degree of specific polarization. The present inventors carried out various experiments to evaluate the degree of specific polarization. As a result, the present inventors discovered that the angle $\beta$ is suitably equal to or greater than 5 degrees, more suitably falls within the range of 30 degrees to 60 degrees. In this description, the "degree of specific polarization" refers herein to a value obtained by normalizing the degree of polarization of a semiconductor light-emitting element with a striped structure that satisfies $\beta$ = x (where 0 < x ≤ 90) with that of a semiconductor light-emitting element with a striped structure that satisfies $\beta$ = 0, and is given by the following Equation (7):

$$(degree\ of\ specific\ polarization)\ =\ degree\ of$$

$$polarization\ of\ semiconductor\ light-emitting\ element\ with$$

$$striped\ structure\ that\ satisfies\ \beta\ =\ x\ /\ degree\ of$$

$$polarization\ of\ semiconductor\ light-emitting\ element\ with$$

$$striped\ structure\ that\ satisfies\ \beta\ =\ 0\quad\quad(7)$$

where 0 < x ≤ 90.

Also, as can be seen from FIG. **10,** if the angle $\beta$ has a value other than 0 degrees, the slope **52** becomes not parallel to the a-axis as described above, and therefore, the light incident on the slope **52** comes to have a p-wave component. On the other hand, the upper surface **53** of the projection **50a** is parallel to the a- and c-axes. That is why even if the angle $\beta$ has a value other than 0 degrees, the polarized light produced in the active layer region **22** can still be incident on the upper surface **53** in a direction in which no p-wave component is produced. As a result, in the light going out through the upper surface **53,** the polarization property is not lessened so much as in the light going out through the slope **52.** Nevertheless, as long as each projection **50a** of the striped structure **50** has at least one slope **52,** the polarization property can be lessened compared to a situation where no striped structure is provided.

In view of these considerations, it is recommended that the plurality of projections of the striped structure have no upper surface **53** that is parallel to the second principal surface **10b** that is the light-emitting face. Specifically, the striped structure suitably has projections with a triangular cross-sectional shape such as the one shown in FIG. **5(a)** or a circular or elliptical cross-sectional shape such as the one shown in FIG. **5(c)**. That is why the degree to which the polarization property is lessened and the cross-sectional shape of the projections of the striped structure are suitably determined according to the application of the semiconductor light-emitting element of this embodiment.

Next, the relation between the angle β and the light extraction efficiency will be considered. The light extraction efficiency of a semiconductor light-emitting element with the striped structure **50** on its light-emitting face increases if the light emitted is incident on the slope **52** of the striped structure **50**. This is because even light that would be totally reflected at a flat light-emitting face should be incident on the slope **52** at an angle that is equal to or smaller than the angle of total reflection and some of the light should be extracted out of the light-emitting element. Also, even light that has been incident on the slope **52** at an angle that is equal to or greater than the angle of total reflection should be reflected from the slope **52** to have its direction changed. And when the light is incident on the slope **52** next time, its angle of reflection is more likely to be equal to or smaller than the angle of total reflection. For these reasons, in order to increase the light extraction efficiency, it is beneficial that the light emitted is incident on the slope **52** with high probability. Thus, the pitch **P** of the projections **50a** of the striped structure **50** is suitably small.

FIG. **11(a)** is a top view of the striped structure **50,** and FIG. **11(b)** is an enlarged view of the striped structure. The light emitted from a semiconductor light-emitting element **101** made of a nitride-based semiconductor which uses an m plane as its principal surface has an angle of radiation that is wide in the c-axis direction as shown in FIG. **8(b).** That is why considering the light extraction efficiency described above, the pitch of the striped structure **50** needs to be set along the c-axis.

As shown in FIG. **11(b),** for a pair of adjacent projections **50a,** the pitch **P** is defined perpendicularly to the direction in which the projections **50a** run. If the pitch of a pair of adjacent projections **50a** as measured along the c-axis is called a "apparent pitch **Pr",** the apparent pitch **Pr** is given by the following Equation (8):

$$P_r = \frac{P}{\cos \beta}$$

$$(8)$$

FIG. **12** shows a relation between the angle β and Pr/P, which is obtained by normalizing the apparent pitch **Pr** with the pitch **P.** The inserted graph is an enlarged one in which the angle β falls within the range of 0 degrees through 85 degrees. As the angle β becomes close to 90 degrees, Pr/P rises steeply. That is to say, the light extraction efficiency decreases. As can be seen from FIG. **12,** if the angle [3 < 80 degrees, then Pr/P < 6, a small pitch **Pr** can be secured, and the light extraction efficiency can be increased. If the angle β ≤ 60 degrees, then Pr/P ≤ 2 , a sufficiently small pitch **Pr** can be secured, and high light extraction efficiency is realized. For these reasons, the angle β suitably satisfies either β ≤ 80 degrees or -80 degrees ≤ β, and more suitably satisfies either β ≤ 60 degrees or -60 degrees ≤ β.

Considering the relation between the polarization property and the angle β and the relation between the light extraction efficiency and the angle β described above, to lessen the polarization property sufficiently and increase the light extraction efficiency, the angle β suitably satisfies 5 degrees ≤ |β| ≤ 80 degrees, and more suitably satisfies 3 degrees ≤ |β| ≤ 60 degrees.

By making polarized light incident on the striped structure 50 with such conditions satisfied, the semiconductor light-emitting element of this embodiment can also make improvement on the degree of asymmetry of the light distribution characteristic. FIGS. 13(a) and 12(b) show to what direction a light ray gets refracted in a situation where light is emitted from a semiconductor light-emitting element with no light extraction structure and having a light-emitting face **61** that is parallel to an m plane. FIG. **13(a)** shows how the light ray is refracted when viewed in the a-axis direction. The light that has been incident on the light-emitting face **61** gets refracted toward the light-emitting face 52 and goes out of this semiconductor light-emitting element. As a result, the propagation vector of the transmitted light goes closer to the c-axis direction. Also, as already described with reference to FIG. **8(b),** the propagation vector of the light polarized in the a-axis direction has little a-axis direction components. That is why when viewed in the c-axis direction as shown in FIG. **13(b),** the principal incident light is incident substantially perpendicularly onto the light-emitting face and gets transmitted through the facet almost without getting refracted. This means that the polarized light produced in the active layer region originally has such a light distribution characteristic that the angle of radiation becomes wider in the c-axis direction rather than in the a-axis direction but that as the polarized light goes out of this light-emitting element through the light-emitting face **61** that is parallel to an m plane, the angle of radiation in the c-axis direction becomes even wider.

Consequently, the propagation vector of the light emitted from the semiconductor light-emitting element **101** satisfies the relation (a-axis component) < (c-axis component). This also means that the relation (intensity of light emitted in a-axis direction) < (intensity of light emitted in c-axis direction) is also satisfied. That is to say, this light distribution characteristic is an asymmetric one.

On the other hand, in the semiconductor light-emitting element **101** of this embodiment, the light incident on the slope **52** of the striped structure **50** is transmitted toward the light-emitting face as shown in FIG. **13(c)**. As a result, the propagation vector of the transmitted light points toward the m-axis. That is to say, the incident light is refracted so that the angle of radiation becomes narrower in the c-axis direction. Consequently, the polarized light extracted from this semiconductor light-emitting element **101** has less propagation vectors with the c-axis direction components than the light extracted from the semiconductor light-emitting element having a flat light-emitting face **61.** Consequently, the respective quantities of the a- and c-axis direction components of the propagation vectors become closer to each other and the degree of asymmetry of the light distribution characteristic can be improved.

As can be seen, in the semiconductor light-emitting element of the present invention, the light-emitting face, through which the light produced in the active layer region is extracted, has a striped structure that runs to define an angle that satisfies 5 degrees $\leq |\beta|$, more suitably 30 degrees $\leq |\beta|$, with respect to the a-axis, and therefore, light polarized in the a-axis direction can be incident as a composite wave of s- and p-wave components on the slope and upper surface of projections that form the striped structure. As a result, the light with a decreased degree of polarization can be extracted with the polarization property lessened. In addition, since the striped structure that runs to define an angle that satisfies $|\beta| \leq 80$ degrees, more suitably, $|\beta| \leq 60$ degrees, is provided, the light produced can be incident on the slope of the striped structure efficiently. As a result, the light extraction efficiency can be increased. Moreover, since the light polarized in the a-axis direction is refracted at the boundary between the slope of the projections and outside so as to go toward the m-axis, the degree of asymmetry of the light distribution characteristic can be improved as well.

According to the present invention, a striped structure is provided for the light-emitting face of a semiconductor light-emitting element in order to make the light incident on the striped structure as much as possible with the condition for lessening the polarization property satisfied, instead of keeping high transmittance or low reflectance. In this respect, it can be said that the semiconductor light-emitting element of Patent Document No. 3, which makes light incident on the light-emitting face at a Brewster angle at which the reflectance becomes zero, is based on a totally different idea from the present invention.

Meanwhile, Japanese Laid-Open Patent Publication No. 2001-201746 discloses a similar technique which is related to the present invention in that a striped structure is provided for the light-emitting face. However, Japanese Laid-Open Patent Publication No. 2001-201746 teaches transforming non-polarized light that has been incident on a light guide member into polarized light and outputting the polarized light by forming a plurality of ribs, each having a predetermined height, on the light guide member for use as a backlight for a liquid crystal display element, and the polarized light is controlled totally inversely to the present invention. This technique just uses the fact that the P- and S-wave components of light incident on a plane have different reflectances and different transmittances as shown in FIG. 7, which is quite different from the object, structure and principle of increasing the extraction efficiency of the semiconductor light-emitting element of the present invention described above.

Hereinafter, an exemplary method for fabricating the semiconductor light-emitting element **101** will be described. As shown in FIG. **14,** first of all., a semiconductor multilayer structure **20** is formed. The semiconductor multilayer structure **20** may be formed by an MOCVD (metalorganic chemical vapor deposition) process on a substrate **10** of n-type GaN, for example.

Specifically, an n-type nitride semiconductor layer **21** is grown epitaxially on a substrate **10** made of n-type GaN, of which the principal surface is an m plane. For example, using silicon as an n-type dopant and $Ga(CH_3)_3$ (trimethylgallium (TMG)) and $NH_3$ as source gases, respectively, an n-type nitride semiconductor layer **21** of GaN is deposited to a thickness of about 3 $\mu$m at a growing temperature of approximately 900 degrees Celsius to 1100 degrees Celsius.

Next, an active layer region **22** is formed on the n-type nitride semiconductor layer **21**. The active layer region **22** may have a GaInN/GaN multiple quantum well (MQW) structure in which $Ga_{1-x}In_xN$ well layers, each having a thickness of approximately 9 nm, and GaN barrier layers, each having a thickness of approximately 9 nm, are stacked alternately. In forming the $Ga_{1-x}In_xN$ well layers, the growing temperature is suitably decreased to 800 degrees Celsius in order to introduce In. The emission wavelength is selected according to the intended use of the semiconductor light-emitting element **101** and the In mole fraction x is determined by the wavelength. Specifically, if the wavelength is set to be 450 nm (blue), the In mole fraction x is set to fall within the range of 0.18 through 0.2. On the other hand, if the wavelength is 520 nm (green), then x = 0.29 to 0.31. And if the wavelength is 630 nm (red), then x = 0.43 to 0.44. By controlling the In mole fraction in this manner, a semiconductor light-emitting element **101** which can emit blue, green and red rays and which can be used as an illumination unit is obtained.

Optionally, an undoped GaN layer (not shown) may be deposited to a thickness of about 30 nm on the active layer region **22.** Next, a p-type nitride semiconductor layer **23** is formed on the undoped GaN layer. For example, using $Cp_2Mg$ (cyclopentadienyl magnesium) as a p-type dopant and TMG, $Al(CH_3)_3$ (trimethylaluminum (TMA)) and $NH_3$ as source gases, respectively, a p-type nitride semiconductor layer **23** of $pAl_xGa_{1-x}N$ is deposited to a thickness of about 70 nm at a growing temperature of approximately 900 degrees Celsius to 1100 degrees Celsius. The mole fraction x may be set to be approximately 0.14, for example.

Next, using $Cp_2Mg$ as a dopant, a p-GaN contact layer (not shown) is deposited to a thickness of approximately 0.5 $\mu$m, for example, on the p-type nitride semiconductor layer **23.** After that, the entire substrate is thermally treated at a temperature of approximately 800 degrees Celsius to 900 degrees Celsius for twenty minutes.

Subsequently, a p-type electrode **40** and an n-type electrode **30** are formed. By performing a dry etching process using a chlorine based gas, the p-GaN contact layer, the p-type nitride semiconductor layer **23,** the undoped GaN layer, the active layer region **22** and the n-type nitride semiconductor layer **21** are partially removed to make a recess **31** and expose a part of the n-type nitride semiconductor layer **21.**

Next, on that part of the n-type nitride semiconductor layer **21,** which is exposed at the bottom of the recess **31,** a stack of Ti/Pt layers is formed as the n-type electrode **30.** Meanwhile, a stack of Pd/Pt layers is formed as the p-type electrode **40** on the p-GaN contact layer. After that, a heat treatment process is carried out to alloy the Ti/Pt layers with the n-type nitride semiconductor layer **21** and the Pd/Pt layers with the p-GaN contact layer and form an n-type electrode **30** and a p-type electrode **40** on the n-type nitride semiconductor layer **21** and on the p-GaN contact layer, respectively.

Thereafter, the second principal surface **10b** of the substrate **10** is polished to reduce the thickness of the semiconductor light-emitting element **101** and decrease absorption of light into the semiconductor light-emitting element **101.** The semiconductor light-emitting element **101** may have a thickness of 100 $\mu$m, for example, because the semiconductor light-emitting element 101 can be handled easily when mounting on a circuit board. In this manner, the structure of the semiconductor light-emitting element **101** with a flat light-emitting face **14** as shown in FIG. **14** is completed.

Next, a striped structure **50** is formed on the flat light-emitting face **14.** The striped structure **50** may be formed by any of various methods including a technique that uses a contact exposure system, a technique that uses an electron beam lithography system, a technique that uses nano imprint, and a technique that uses a stepper. In this embodiment, a method for forming the striped structure **50** using a contact exposure system and an electron beam lithography system will be described in detail. In the following description, the second principal surface **10b,** which is the light-emitting face on which the striped structure **50** has not been formed yet, will be referred to herein as a "flat light-emitting face **14**".

First of all, an SiO$_2$ film is deposited as a hard mask material on the flat light-emitting face **14.** The SiO$_2$ film may be deposited by plasma chemical vapor deposition (p-CVD) process, for example. Next, a photoresist is applied onto the hard mask. After the photoresist has been applied, an exposure process is carried out using a contact exposure system or an electron beam lithography system and then a development process is performed to define a resist pattern including a plurality of stripes that run in a direction that satisfies 5 degrees $\leq |\beta| \leq$ 80 degrees, more suitably 30 degrees $\leq |\beta| \leq$ 60 degrees, with respect to the a-axis.

Thereafter, using the resist pattern as a mask, the hard mask is dry-etched using CF$_4$ gas and O$_2$ gas, for example. Next, using the hard mask as a mask, the flat light-emitting face **14** is dry-etched using a chlorine based gas, for example. Finally, the hard mask is removed by dry etching. In this manner, a semiconductor light-emitting element **101,** including the striped structure **50** on the second principal surface **10b** of the substrate **10** as shown in FIG. **3,** is completed.

The striped structure **50** may also be formed on the flat light-emitting face **14** in the following manner. First, a photoresist is applied onto the' flat light-emitting face **14,** an exposure process is performed using a contact exposure system, and then a development process is carried out to define a resist pattern including a plurality of stripes that run in a direction which defines 5 degrees $\leq |\beta| \leq$ 80 degrees (more suitably, 30 degrees $\leq |\beta| \leq$ 60 degrees) with respect to the a-axis. By heating the photoresist, dry etch resistance is increased. Thereafter, by using the photoresist as a mask, the flat light-emitting face **14** is dry etched using a chlorine-based gas. As a result, the photoresist is also removed at the same time. In this manner, a semiconductor light-emitting element **101,** including the striped structure **50** on the second principal surface **10b** of the substrate **10,** is completed.

The semiconductor multilayer structure **20** does not have to be formed on an n-type GaN substrate, of which the principal surface is an m plane, but may also be an m-plane GaN layer which has been formed, by crystal growing process, on an SiC substrate, a sapphire substrate, an LiAlO$_2$ substrate, a Ga$_2$O$_3$ substrate, an SiC substrate, or an Si substrate. In that case, before a nitride-based semiconductor is grown epitaxially on any of these substrates, the striped structure **50** may be formed in advance. And after the semiconductor has been grown epitaxially, the substrate is removed by laser lift off process, for example. In this case, the striped structure **50** that has been formed before the semiconductor is epitaxially grown is transferred onto the nitride-based semiconductor. That is why a semiconductor light-emitting element **101** with the striped structure **50** can be eventually obtained by removing the substrate. The semiconductor light-emitting element **101** may be completed in this manner, too. To grow an m-plane nitride-based semiconductor epitaxially on a substrate, the plane orientation of the SiC or sapphire substrate is suitably an m plane, too. However, it was reported that a-plane GaN could grow on an r-plane sapphire substrate. That is why to grow a semiconductor layer, of which the principal surface is an m plane, the principal surface of the substrate **10** does not have to be an m plane but the active layer region **22** needs to be parallel to an m plane and its crystal growing direction needs to be perpendicular to the m plane, to say the least.

(EMBODIMENT 2)

FIG. **15** schematically illustrates a cross-sectional structure of a semiconductor light-emitting element as a second embodiment of the present invention. As shown in FIG. **15,** the semiconductor light-emitting element **102** includes a substrate **10,** a semiconductor multilayer structure **20** which has been formed on the first principal surface **10a** of the substrate **10** and which includes an active layer region **22,** and a light output member **13** which is arranged on the second principal surface **10b** of the substrate **10.** The semiconductor multilayer structure **20** further includes an n-type electrode **30** and a p-type electrode **40.** The semiconductor multilayer structure **20,** the n-type electrode **30** and the p-type electrode **40** have the same structures as their counterparts of the first embodiment described above.

The light output member **13** is arranged in contact with the second principal surface **10b** of the substrate **10,** which is opposite from the other surface with the semiconductor multilayer structure **20.** The first principal surface **13a** of the light output member **13** is in contact with the substrate **10** and the second principal surface **13b** thereof has the striped structure **50.** The light output member **13** is made of a material other than a GaN semiconductor such as $SiO_2$, SiN, SiC, $TiO_2$, sapphire, $LiAlO_2$, or $Ga_2O_3$ which transmits the polarized light produced in the active layer region **22.** More suitably, the light output member **13** is made of a material which can be easily patterned by dry etching, for example.

Generally speaking, a dry etching process to be performed on a nitride-based semiconductor such as the substrate **10** made of n-type GaN has some problems such as a low etch rate and difficulty to control the sidewall shape. However, by providing a light output member **13** made of such a material, the striped structure **50** can be formed more easily. Also, if $SiO_2$ or SiN is used as a material for the light output member **13,** the striped structure **50** can be formed by performing a wet etching process using an aqueous solution including hydrofluoric acid.

Also, the refractive index no of the light output member **13** is suitably equal to or greater than the refractive index $n_t$ of an external medium with which the second principal surface **13b** with the striped structure **50** contacts (i.e., $n_t$ < no). Thus, compared to a situation where the polarized light is transmitted through the substrate **10** and extracted directly, the transmittance of the light through the second principal surface **10b** of the substrate **10** can be increased, and eventually, the light extraction efficiency can be further increased.

The degree of polarization of the polarized light extracted through the light output member **13** depends on the refractive index $n_o$ of the constituent material of the light output member **13,** the angle β defined by the direction in which the projections **50a** of the striped structure **50** run with respect to the a-axis (see FIG. **4(c)**), and the slope **52** with respect to an m plane.

This semiconductor light-emitting element **102** may be fabricated in the following manner, for example.

First of all, as shown in FIG. **14,** a semiconductor multilayer structure **20** is formed on the substrate **10** by the same method as the one adopted in the first embodiment. As the substrate **10,** an n-type GaN substrate, an SiC substrate, a sapphire substrate, an $LiAlO_2$ substrate, or a $Ga_2O_3$ substrate may be used as long as their principal surface is an m plane. An n-type electrode **30** and a p-type electrode **40** are also formed.

Thereafter, a light output member **13** is formed on the second principal surface **10b** of the substrate **10.** If the light output member **13** needs to be made of $SiO_2$, an $SiO_2$ film is formed by plasma chemical vapor deposition process, for example. In this case, the thicker the $SiO_2$ film, the lower its film quality and its transmittance will be. For that reason, the light output member **13** suitably has a thickness of 10 μm or less.

After that, a resist pattern is defined on the $SiO_2$ film and the $SiO_2$ film is selectively etched using the resist pattern as already described for the first embodiment. For example, by dry-etching the $SiO_2$ film using a mixture of $CF_4$ and $O_2$ gases, the striped structure **50** can be formed more easily and with more controllability than in a situation where the substrate **10** made of a nitride semiconductor is etched. In this manner, the semiconductor light-emitting element **102** shown in FIG. **14** is completed.

(EMBODIMENT 3)

FIG. **16** schematically illustrates a cross-sectional structure of a semiconductor light-emitting element as a third embodiment of the present invention. As shown in FIG. **16,** the semiconductor light-emitting element **103** includes a substrate **10,** a semiconductor multilayer structure **20** which has been formed on the first principal surface **10a** of the substrate **10** and which includes an active layer region **22,** an n-type electrode **30** and a p-type electrode **40.**

In this semiconductor light-emitting element **103,** the semiconductor multilayer structure **20** has no recess **31** and the n-type electrode **30** is arranged on the second principal surface **10b** of the substrate **10** with the striped structure **50,** which is a major difference from the first embodiment described above. The semiconductor multilayer structure **20,** the p-type electrode **40** and the striped structure **50** are the same as their counterparts of the first embodiment.

As shown in FIG. **16,** the n-type electrode **30** is a stack of Ti and Pt layers (Ti/Pt) and is arranged so as to partially cover the striped structure **50.** As there is no need to make any recess **31** in the semiconductor multilayer structure **20** in this semiconductor light-emitting element **103,** its element structure can be simplified and the manufacturing cost can be cut down.

This semiconductor light-emitting element **103** may be fabricated in the following manner. First of all, as already described for the first embodiment, a semiconductor multilayer structure **20** is formed on the first principal surface **10a** of the substrate **10.** Thereafter, the substrate **10** is polished until the overall thickness thereof becomes approximately 100 μm. Next, a striped structure **50** is formed on the second principal surface **10b** of the substrate **10** as already described for the first embodiment.

After the striped structure **50** has been formed, electrodes are formed. First of all, a stack of Ti/Pt layers, for example, is formed as an n-type electrode **30** on a part of the second principal surface **10b** with the striped structure **50**. Meanwhile, a stack of Pd/Pt layers, for example, is formed as a p-type electrode **40** on the p-type nitride semiconductor layer **23**. After that, a heat treatment process is carried out to alloy the Ti/Pt layers with the substrate **10** and the Pd/Pt layers with the p-GaN contact layer and form an n-type electrode **30** and a p-type electrode **40** which are electrically connected to the substrate **10** and the p-GaN contact layer, respectively. In this manner, the semiconductor light-emitting element **103** shown in FIG. **15** is completed.

(EMBODIMENT 4)

FIG. **17** schematically illustrates a cross-sectional structure of a semiconductor light-emitting element as a fourth embodiment of the present invention. As shown in FIG. **17**, the semiconductor light-emitting element **104** includes a substrate **10**, a semiconductor multilayer structure **20** which has been formed on the first principal surface **10a** of the substrate **10** and which includes an active layer region **22**, and a light output member **13**, an n-type electrode **30** and a p-type electrode **40**.

In this semiconductor light-emitting element **104**, the light output member **13** is arranged to cover the striped structure **50** on the second principal surface **10b** of the substrate **10**, which is a major difference from the first embodiment, and the substrate **10** does have the striped structure **50**, which is a major difference from the second embodiment. The semiconductor multilayer structure **20**, the n-type electrode **30**, the p-type electrode **40** and the striped structure **50** have the same structures as their counterparts of the first embodiment described above.

The refractive index **no** of the light output member **13** that covers the striped structure **50** on the second principal surface **10a** of the substrate **10** is suitably greater than the refractive index $n_t$ of a medium outside of this semiconductor light-emitting element **104** (i.e., $n_t < n_o$). Also, the light output member **13** suitably has high transmittance with respect to the polarized light produced in the active layer region **22**. Thus, compared to a situation where the polarized light is transmitted through the substrate **10** and extracted directly, the transmittance of the light through the second principal surface **10b** of the substrate **10** can be increased, and eventually, the light extraction efficiency can be further increased. The light output member **13** is made of a material other than a GaN semiconductor such as $SiO_2$, SiN, SiC, $TiO_2$, sapphire, $LiAlO_2$, or $Ga_2O_3$ which transmits the polarized light produced in the active layer region **22**.

The light output member **13** may either completely fill the grooves **50b** of the striped structure **50** to make the second principal surface **13b**, which contacts with the external medium, totally flat or have a striped structure **50'** corresponding to the striped structure **50** of the second principal surface **13b**. The refractive index $n_o$ of the light output member 13 suitably satisfies $n_t < no < n_1$, where $n_1$ is the refractive index of the substrate **10**. By changing the refractive index stepwise from $n_1$ through $n_t$ in this manner, the transmittance to the polarized light produced in the active layer region 22 can be further increased.

The semiconductor light-emitting element **104** may be fabricated in the following manner, for example. First of all, the semiconductor multilayer structure **20**, the n-type electrode **30** and the p-type electrode **40** are formed on the substrate **10** as already described for the first embodiment. Meanwhile, the striped structure **50** is formed on the second principal surface **10b** of the substrate **10**.

After that, the output member **13** is deposited. If an $SiO_2$ film is deposited as the output member **13**, a plasma chemical vapor deposition process may be used. Thereafter, if necessary, the striped structure **50'** is formed on the light output member **13** by the method that has already been described for the second embodiment.

(EMBODIMENT 5)

FIG. **18** schematically illustrates a cross-sectional structure of a semiconductor light-emitting element as a fifth embodiment of the present invention. As shown in FIG. **18**, the semiconductor light-emitting element **105** includes a substrate **10**, a semiconductor multilayer structure **20** which has been formed on the first principal surface **10a** of the substrate **10** and which includes an active layer region **22**, and a light output member **13**, an n-type electrode **30** and a p-type electrode **40**.

In this semiconductor light-emitting element **105**, the light output member **13** is arranged on the p-type nitride semiconductor layer **23** and the polarized light produced in the active layer region **22** is transmitted through the p-type nitride semiconductor layer **23** and extracted through the light output member **13**, which is a major difference from the first embodiment described above.

As shown in FIG. **18**, the second principal surface **23b** of the p-type nitride semiconductor layer **23** is closer to the active layer region **23**. The light output member **13** is arranged on the first principal surface **23a** of the p-type nitride semiconductor layer **23**. The first principal surface **13a** of the light output member **13**, which does not contact with the p-type nitride semiconductor layer **23**, is a light-emitting face, and the striped structure **50** has been formed on the first principal surface **13a.** The p-type electrode **40** is arranged on a part of the first principal surface **23a** of the p-type nitride semiconductor layer **23.**

The n-type electrode **30** is arranged on, and electrically connected to, the second principal surface **10b** of the substrate **10.** The semiconductor multilayer structure **20** and the striped structure **50** have the same structures as their counterparts of the first embodiment described above.

The light output member **13** is made of a material other than a GaN semiconductor such as $SiO_2$, SiN, SiC, $TiO_2$, sapphire, $LiAlO_2$, or $Ga_2O_3$ which transmits the polarized light produced in the active layer region **22.** More suitably, the light output member **13** is made of a material which can be easily patterned by dry etching, for example. Also, the refractive index **no** of the light output member **13** is suitably equal to or greater than the refractive index $n_t$ of an external medium with which the first principal surface **13a** with the striped structure **50** contacts (i.e., $n_t < n_o$). Thus, compared to a situation where the polarized light is transmitted through the p-type nitride semiconductor layer **23** and extracted directly, the transmittance of the light through the first principal surface **23a** of the p-type nitride semiconductor layer **23** can be increased.

On top of that, compared to the second embodiment, the interval between the light output member **13** and the active layer region **22** can be shortened and absorption of the polarized light produced in the active layer region **22** into the semiconductor layer can be reduced. As a result, the light extraction efficiency can be further increased. Furthermore, as already described for the second embodiment, the striped structure **50** can also be formed easily.

This semiconductor light-emitting element **105** may be fabricated in the following manner. First of all, as already described for the first embodiment, a semiconductor multilayer structure **20** is formed on the substrate **10** as shown in FIG. **17.** Thereafter, the substrate **10** is polished until the overall thickness thereof becomes approximately 100 μm.

Next, electrodes are formed. First of all, a stack of Ti/Pt layers, for example, is formed as an n-type electrode **30** on the second principal surface **10b** of the substrate **10.** Meanwhile, a stack of Pd/Pt layers, for example, is formed as a p-type electrode **40** on a part of the p-type nitride semiconductor layer **23.** After that, a heat treatment process is carried out to alloy the Ti/Pt layers with the substrate **10** and the Pd/Pt layers with the p-GaN contact layer and form an n-type electrode **30** and a p-type electrode **40** which are coupled to the substrate **10** and the p-GaN contact layer, respectively.

After the electrodes have been formed, a light output member **13** is formed on the first principal surface **23a** of the p-type nitride semiconductor layer **23.** If the light output member **13** needs to be made of $SiO_2$, an $SiO_2$ film is deposited by plasma chemical vapor deposition process, for example. In this case, the thicker the $SiO_2$ film, the lower its film quality and its transmittance will be. For that reason, the light output member **13** suitably has a thickness of 10 μm or less.

Thereafter, a resist pattern is defined on the $SiO_2$ film and the $SiO_2$ film is selectively etched using the resist pattern as already described for the first embodiment. For example, by dry-etching the $SiO_2$ film using a mixture of $CF_4$ and $O_2$ gases, the striped structure **50** can be formed easily and with good controllability.

Finally, a resist pattern is defined on the striped structure **50** and the $SiO_2$ film is selectively etched using the resist pattern (e.g., wet-etched with hydrofluoric acid) to expose the p-type electrode **40.** In this manner, the semiconductor light-emitting element **105** shown in FIG. **18** is completed.

(EMBODIMENT 6)

FIG. **19** schematically illustrates a cross-sectional structure of a semiconductor light-emitting element as a sixth embodiment of the present invention. As shown in FIG. **19,** the semiconductor light-emitting element **106** includes a substrate **10,** a semiconductor multilayer structure **20** which has been formed on the first principal surface **10a** of the substrate **10** and which includes an active layer region **22,** an n-type electrode **30** and a p-type electrode **40.**

In this semiconductor light-emitting element **106,** the striped structure **50** has been formed on the first principal surface **23a** of the p-type nitride semiconductor layer **23** and the p-type electrode **40** has been formed over the entire surface of the striped structure **50,** which are major differences from the fifth embodiment.

The p-type electrode **40** is a transparent electrode made of ITO in this embodiment. Optionally, a sufficiently thin metal layer which makes ohmic contact with the p-type nitride semiconductor layer **23** may be interposed between the transparent electrode and the p-type nitride semiconductor layer **23.** In this semiconductor light-emitting element **106,** the p-type electrode **40** can cover the entire first principal surface **23a** of the p-type nitride semiconductor layer **23,** and therefore, low-resistance p-type ohmic contact is realized.

This semiconductor light-emitting element **106** may be fabricated in the following manner. First of all, as already described for the first embodiment, a semiconductor multilayer structure **20** is formed on the substrate **10** as shown in FIG. **19.** Thereafter, the substrate **10** is polished until the overall thickness thereof becomes approximately 100 μm. Next, a striped structure **50** is formed on the first principal surface **23a** of the p-type nitride semiconductor layer **23** and then electrodes are formed. First of all, a stack of Ti/Pt layers, for example, is formed as an n-type electrode **30** on the substrate **10.** Meanwhile, an ITO layer, for example, is formed as a p-type electrode **40** on the striped structure **50.** After that, a heat treatment process is carried out to alloy the Ti/Pt layers with the substrate **10** and the ITO layer with the p-type nitride semiconductor layer **23** and form an n-type electrode **30** and a p-type electrode **40** which are coupled to the substrate **10** and the p-type nitride semiconductor layer, respectively. In this manner, the semiconductor light-emitting element **106** shown in FIG. **19** is completed.

(EMBODIMENT 7)

FIG. **20** schematically illustrates a cross-sectional structure of a semiconductor light-emitting element as a seventh embodiment of the present invention. As shown in FIG. **20,** the semiconductor light-emitting element **107** includes a substrate **10,** a semiconductor multilayer structure **20** which has been formed on the first principal surface **10a** of the substrate **10** and which includes an active layer region **22,** an n-type electrode **30** and a p-type electrode **40.**

In this semiconductor light-emitting element **107,** the p-type electrode **40** covers only a part of the striped structure **50** on the first principal surface **23a** of the p-type nitride semiconductor layer **23,** which is a major difference from the sixth embodiment described above. By providing such a small p-type electrode **40,** absorption of light into the p-type electrode **40** can be reduced, and the light extraction efficiency can be increased, compared to the sixth embodiment.

This semiconductor light-emitting element **107** may be fabricated in the following manner. First of all, as already described for the first embodiment, a semiconductor multilayer structure **20** is formed on the substrate **10** as shown in FIG. **20.** Thereafter, the substrate **10** is polished until the overall thickness thereof becomes approximately 100 $\mu$m. Next, a striped structure **50** is formed on the first principal surface **23a** of the p-type nitride semiconductor layer **23** and then electrodes are formed. First of all, a stack of Ti/Pt layers, for example, is formed as an n-type electrode **30** on the substrate **10.** Meanwhile, a stack of Pd/Pt layers, for example, is formed as a p-type electrode **40** on only a part of the striped structure **50.** After that, a heat treatment process is carried out to alloy the Ti/Pt layers with the substrate **10** and the Pd/Pt layers with the p-type nitride semiconductor layer **23** and form an n-type electrode **30** and a p-type electrode **40** which are coupled to the substrate **10** and the p-type nitride semiconductor layer, respectively. In this manner, the semiconductor light-emitting element **107** shown in FIG. **20** is completed.

**Examples**

To confirm the effects of the present invention, various semiconductor light-emitting elements were fabricated by the manufacturing process of the first embodiment and had their performance evaluated.

(Making Example 1, Reference Example 1 and Comparative Example 1)

First of all, as shown in FIG. **3,** a semiconductor multilayer structure **20** was grown epitaxially on a substrate **10** by MOCVD (metalorganic chemical vapor deposition) process. Specifically, an n-type nitride semiconductor layer **21** was grown epitaxially on an n-type GaN substrate, of which the principal surface was an m plane. For example, using silicon as an n-type dopant and supplying TMG ($Ga(CH_3)_3$) and $NH_3$ as source gases to a reaction chamber, an n-type nitride semiconductor layer **21** of GaN was deposited to a thickness of 3 $\mu$m at a growing temperature of approximately 1050 degrees Celsius.

Next, an active layer region **22** was formed on the n-type nitride semiconductor layer **21.** The active layer region **22** had a GaInN/GaN multiple quantum well (MQW) structure in which $Ga_{1-x}In_xN$ well layers (where x = 0.19), each having a thickness of 9 nm, and GaN barrier layers, each having a thickness of 9 nm, were stacked alternately. When the $Ga_{1-x}In_xN$ well layers were formed, the growing temperature was lowered to 800 degrees Celsius in order to introduce In.

Next, an undoped GaN layer (not shown) was deposited to a thickness of 30 nm on the active layer region **22.** Subsequently, a p-type nitride semiconductor layer **23** was formed on the undoped GaN layer. Using $Cp_2Mg$ (cyclopentadienyl magnesium) as a p-type dopant and supplying TMG, TMA and $NH_3$ as source gases to a reaction chamber, a p-type nitride semiconductor layer **23** of $p-Al_{0.14}Ga_{0.86}N$ was deposited to a thickness of about 70 nm at a growing temperature of 1050 degrees Celsius.

Next, using $Cp_2Mg$ as a dopant, a p-GaN contact layer (not shown) was deposited to a thickness of 0.5 $\mu$m on the p-type nitride semiconductor layer **23.**

Subsequently, by performing a dry etching process using a chlorine based gas, the p-GaN contact layer, the p-type nitride semiconductor layer **23,** the undoped GaN layer, the active layer region **22** and the n-type nitride semiconductor layer **21** were partially removed to make a recess **31** and expose a part of the n-type nitride semiconductor layer **21.**

Next, on that part of the n-type nitride semiconductor layer **21,** which was exposed at the bottom of the recess **31,** a stack of Ti/Pt layers was formed as the n-type electrode **30.** Meanwhile, a stack of Pd/Pt layers was formed as the p-type electrode **40** on the p-GaN contact layer. After that, a heat treatment process was carried out to alloy the Ti/Pt layers with the n-type nitride semiconductor layer **21** and the Pd/Pt layers with the p-GaN contact layer and form an n-type electrode **30** and a p-type electrode **40** on the n-type nitride semiconductor layer **21** and on the p-GaN contact layer, respectively.

Thereafter, the substrate **10** was polished to reduce the overall thickness to 100 $\mu$m. In this manner, a portion functioning as a semiconductor light-emitting element was completed.

Next, a striped structure **50** was formed. First of all, an SiO$_2$ film was deposited as a hard mask material on the second principal surface **10b** of the substrate **10.** The SiO$_2$ film was deposited by plasma chemical vapor deposition process. Next, a photoresist for electron beam lithography was applied onto the hard mask and was patterned using an electron beam lithography system. Thereafter, using the electron beam lithography photoresist as a mask, the hard mask was dry-etched with CF$_4$ gas and O$_2$ gas. Next, using the hard mask as a mask, the second principal surface **10b** of the substrate **10** was dry-etched using a chlorine based gas. Finally, the hard mask was removed by dry etching. In this manner, a semiconductor light-emitting element was completed.

The striped structure had a pitch **p** of 300 nm and its height **h** was set to be 300 nm. Its cross-sectional shape was a roughly trapezoidal one. FIG. **21(a)** is a schematic representation illustrating the cross-sectional shape. In this case, Reference Example 1 in which the stripes ran parallel to the a-axis (i.e., $\beta$ = 0), Example 1 in which the stripes defined an angle of 45 degrees with respect to the a-axis (i.e., $\beta$ = 45), and Comparative Example 1 in which the stripes crossed the a-axis at right angles (i.e., $\beta$ = 90) were made.

(Making Example 2, Reference Example 2 and Comparative Example 2)

A portion functioning as a semiconductor light-emitting element was made in the same procedure as in Example 1, Reference Example 1 and Comparative Example 1. After that, a striped structure was made in a different procedure from in Example 1, Reference Example 1 and Comparative Example 1. Specifically, an SiO$_2$ film was deposited as a hard mask material on the second principal surface **10b** of the substrate **10.** The SiO$_2$ film was deposited by plasma chemical vapor deposition process. Next, a photoresist was applied onto the hard mask and was patterned using a contact exposure system. Thereafter, using the photoresist as a mask, the hard mask was dry-etched with CF$_4$ gas and O$_2$ gas. Next, using the hard mask as a mask, the second principal surface **10b** of the substrate **10** was dry-etched using a chlorine based gas. Finally, the hard mask was removed by dry etching. In this manner, a semiconductor light-emitting element was fabricated.

The striped structure had a pitch **p** of 8 $\mu$m and its height **h** was set to be 4 $\mu$m. Its cross-sectional shape was a roughly trapezoidal one. FIG. **21(a)** is a schematic representation illustrating the cross-sectional shape. In this case, Reference Example 2 in which the stripes ran parallel to the a-axis (i.e., $\beta$ = 0), Example 2 in which the stripes defined an angle of 45 degrees with respect to the a-axis (i.e., $\beta$ = 45), and Comparative Example 2 in which the stripes crossed the a-axis at right angles (i.e., $\beta$ = 90) were made.

(Making Example 3, Reference Example 3 and Comparative Example 3)

Semiconductor light-emitting elements, of which the striped structure defined angles $\beta$ of 0, 5, 30, 45 and 90 degrees, respectively, with respect to the a-axis, were fabricated. First of all, a portion functioning as a semiconductor light-emitting element was made in the same procedure as in Example 1, Reference Example 1 and Comparative Example 1. After that, a striped structure was made in a different procedure from in Example 1, Reference Example 1 and Comparative example 1. Specifically, a photoresist was applied onto the second principal surface **10b** of the substrate **10** and was patterned using a contact exposure system and then heated to 230 degrees Celsius. Thereafter, using the photoresist as a mask, the second principal surface **10b** of the substrate **10** was dry-etched using a chlorine based gas. In this process step, the photoresist was also removed at the same time as a result of the dry etching process. In this manner, a semiconductor light-emitting element was fabricated.

The striped structure had a pitch **p** of 8 $\mu$m and its height **h** was set to be 2.5 $\mu$m. By making the striped structure by the manufacturing process described above, a different cross-sectional shape from that of Example 2, Reference Example 2 and Comparative Example 2 could be obtained. Specifically, its cross-sectional shape was a roughly isosceles triangular one. FIG. **21(b)** is a schematic representation illustrating the cross-sectional shape. In this case, Reference Example 3 in which the stripes ran parallel to the a-axis (i.e., $\beta$ = 0), Example 3 in which the stripes defined angles of 5, 30 and 45 degrees with respect to the a-axis (i.e., $\beta$ = 5, 30, 45), and Comparative Example 3 in which the stripes crossed the a-axis at right angles (i.e., $\beta$ = 90) were made.

(Making Comparative Example 4)

A semiconductor light-emitting element, including every member of Example 1 but the striped structure **50,** was fabricated as Comparative Example 4 in the same procedure as in Example 1.

(Evaluating the performances of Examples 1 to 3, Reference Examples 1 to 3 and Comparative Examples 1 to 4)

The performances of the semiconductor light-emitting elements thus fabricated were evaluated. To confirm that most of the propagation vectors **k** were present within a plane parallel to the mc plane (see FIG. **8(a)**), the light distribution characteristic of the semiconductor light-emitting element of Comparative Example 4 was measured. FIG. **22(a)** is a graph showing the results of measurement of the light distribution characteristic. FIG. **23** schematically illustrates the arrangement of a system that was used for measurement. The semiconductor light-emitting element of Comparative Example 4 was flip-chip bonded and was used for measurement as a light-emitting element chip 71. By supplying current from a power supply **72** to the light-emitting element chip **71,** light was emitted. The light-emitting element chip **71** was rotated on the z-axis shown in FIG. **23** and the light intensity was measured with a photodetector **73.** The a-axis shown in FIG. **22(a)** is a result of measurement obtained by defining the x-, y- and z-axes shown in FIG. **23** to be m-, a-and c-axes, respectively. The c-axis shown in FIG. **22(a)** is a result of measurement obtained by defining the x-, y- and z-axes shown in FIG. **23** to be m-, c- and a-axes, respectively.

As can be seen from FIG. **22(a),** the light intensity has a strong light distribution characteristic over a wider angle in the c-axis direction than in the a-axis direction. That is to say, the angle of radiation is wider in the c-axis direction than in the a-axis direction and the light distribution characteristic has a degree of asymmetry. FIGS. **22(b)** and **22(c)** schematically illustrate the results shown in FIG. **22 (a)**. In FIG. **22 (b),** the light traveling in the mc plane is illustrated schematically, and it can be seen that intense light is emitted over a wide range in the mc plane. On the other hand, in FIG. **22(c),** the light traveling in the ma plane is illustrated schematically, and it can be seen that intense light is emitted in the m-axis direction. Also, there is little light with the a-axis direction component. In this case, the light emitted in the m-axis direction is shared by the mc plane and the ma plane. These results reveal that the light produced is mostly present within the mc plane.

Next, the light distribution characteristics of the semiconductor light-emitting elements of Example 1, Reference Example 1 and Comparative Example 1 were measured. The system used for measurement also has the arrangement shown in FIG. **23**. FIG. **24** is a graph showing the results of measurement of the light distribution characteristics of the semiconductor light-emitting elements of Reference Example 1 ($\beta = 0$), Example 1 ($\beta = 45$) and Comparative Example 1 ($\beta = 90$). FIG. **24(a)** shows the results of measurement obtained in the a-axis direction and FIG. **24(b)** shows the results of measurement obtained in the c-axis direction. In this case, the a-axis direction is a result of measurement obtained by defining the x-, y- and z-axes shown in FIG. 23 to be m-, a- and c-axes, respectively. The c-axis direction is a result of measurement obtained by defining the x-, y- and z-axes shown in FIG. 22 to be m-, c- and a-axes, respectively. As can be seen from FIG. **24(a),** the light distribution characteristic in the a-axis direction does not depend on the angle $\beta$. It can also be seen that the light distribution characteristic in the c-axis direction, on the other hand, is that if the angle $\beta$ is equal to or smaller than 45 degrees, the percentage of the light intensities in the vicinity of zero degrees, i.e., in the m-axis direction, increases. That is to say, it can be seen that if the angle $\beta$ is equal to or smaller than 45 degrees, the respective light distribution characteristics in the a-and c-axis directions become similar to each other. These results reveal that in the semiconductor light-emitting element of Example 1, the degree of asymmetry of the light distribution characteristic was improved.

Next, the present inventors confirmed how much degree of polarization was lessened in the polarized light emitted. FIG. 25 shows the results of measurements on the relation between the pitch p of the striped structure 50, the angle $\beta$, and the percentage of the degree of polarization maintained. In this case, the "semiconductor light-emitting element S" is a generic term that collectively refers to Examples 1 and 2, Reference Examples 1 and 2, and Comparative Examples 1 and 2. Also, the "percentage of the degree of polarization maintained" refers to how much degree of polarization was maintained with respect to the degree of polarization of Comparative Example 4 with no striped structure and is calculated by the following Equation (9):

```
(percentage of degree of polarization maintained)

= (degree of polarization of semiconductor light-

emitting element S) / (degree of polarization of

comparative example)                                (9)
```

FIG. 26 schematically illustrates the arrangement of a system that was used for measurement. Either the semiconductor light-emitting element **S** or the semiconductor light-emitting element of Comparative Example 4 was flip-chip bonded and was used as a light-emitting element chip **71** for measurement. By supplying current from the power supply **72** to the light-emitting element chip **71,** light was emitted. The light emitted from the light-emitting element chip **71** was transmitted through a polarizer **74** and had its intensity detected by a photodetector **73.** If the light emitted from the light-emitting element chip **71** included polarized light, a variation in the intensity of the light would be observed by rotating the polarizer **74.**

As shown in FIG. 25, if the angles $\beta$ were 45 degrees and 90 degrees in the striped structure with a pitch of at least 300 nm to 8 $\mu$m, the degree of polarization decreased to approximately 70%. It can also be seen that if the angle $\beta$ was 0 degrees, on the other hand, the degree of polarization was maintained.

To inspect the relation between the angle $\beta$ and the degree of polarization more closely, the degrees of polarization of the semiconductor light-emitting elements of Example 3, Reference Example 3 and Comparative Example 3 were measured. FIG. 27 shows the results of measurement obtained in Example 3, Reference Example 3 and Comparative Example 3. The results of measurement were evaluated as degrees of specific polarization. The "degree of specific polarization" is represented by Equation (7). More specifically, the "degree of specific polarization" refers to a value obtained by normalizing the degree of polarization of Example 3 or Comparative Example 3 with that of Reference Example 3 and is calculated by the following Equation (10):

$$\text{(degree of specific polarization)} = \text{(degree of polarization of Example 3 or Comparative Example 3)} / \text{(degree of polarization of reference Example 3)} \qquad (10)$$

As shown in FIG. 27, if the angle $\beta$ was 5 degrees or more, the degree of polarization decreased significantly to 0.4 or less. Particularly when the angle $\beta$ was equal to or greater than 30 degrees, the degree of specific polarization decreased to 0.25 or less. It can also be seen that the degree of specific polarization decreased more gently after that, and reached a minimum value when the angle $\beta$ was in the vicinity of 45 degrees. Thus, it can be said that if the direction in which projections run during the manufacturing process of a semiconductor light-emitting element has an error of approximately 5 degrees, the angle $\beta$ most suitably falls within the range of 40 degrees to 50 degrees.

According to the results of measurement shown in FIG. 25, the percentage of the degree of polarization maintained was 50% or more at angles $\beta$ of 45 and 90 degrees. According to the results of measurement shown in FIG. 27, on the other hand, the percentage of the degree of polarization maintained was approximately 20% at angles $\beta$ of 45 and 90 degrees. This difference would be caused by a difference in cross-sectional shape between the projections of the striped structure as described above.

More specifically, in the semiconductor light-emitting element from which the results of measurement shown in FIG. 25 were obtained, the cross-sectional shape of each projection **53a** of its striped structure has an upper surface **53** as shown in FIG. **21(a),** and the light extracted through the upper surface **53** does not have its polarization property lessened sufficiently as described above. That is why in the semiconductor light-emitting element, from which the results of measurement shown in FIG. **25** were obtained, if the angle $\beta$ is greater than zero degrees, the degree of polarization of the outgoing light would be kept relatively high. On the other hand, in the semiconductor light-emitting element from which the results of measurement shown in FIG. **27** were obtained, the cross-sectional shape of each projection **53a** of its striped structure has no upper surface as shown in FIG. **21(b),** and therefore, its polarization property would be lessened to a greater degree.

As can be seen, the percentage of the degree of polarization maintained varies according to the cross-sectional shape of each projection of the striped structure. However, the dependence of the effect of lessening the polarization property by the slope on the angle $\beta$ would be no different irrespective of the cross-sectional shape. That is why no matter what cross-sectional shape each projection of the striped structure has, the angle $\beta$ would suitably fall within the range of 5 degrees to 80 degrees, more suitably within the range of 30 degrees to 60 degrees, and most suitably should be around 45 degrees.

Next, the light extraction efficiencies were checked out. FIG. **28** shows the results of measurement obtained from the semiconductor light-emitting elements of Example 1, Reference Example 1 and Comparative Example 1 on the relation between the specific light extraction efficiency and the angle $\beta$. In this description, the "specific light extraction efficiency" refers to a value obtained by normalizing the light extraction efficiency of the semiconductor light-emitting element of Example 1, Reference Example 1 or Comparative Example 1 with that of the semiconductor light-emitting element having a flat light-emitting face of Comparative Example 3. As can be seen from FIG. **28,** by forming the striped structure **50** on the flat light-emitting face **14,** the specific light extraction efficiency becomes greater than one, specifically, 1.1 or more. Particularly, when the angles β are 0 degrees and 45 degrees, the specific light extraction efficiency becomes 1.2 or more, and it can be seen that the light extraction efficiency increased significantly.

As can be seen, the semiconductor light-emitting element according to Example 1, 2 or 3 can reduce the degree of asymmetry of the light distribution characteristic as shown in FIG. **24,** can lessen the polarization property of the polarized light as shown in FIGS. **25** and **27,** and can increase the light extraction efficiency significantly as shown in FIG. **28.** Thus, the semiconductor light-emitting element according to Example 1, 2 or 3 turned out to be usable as a light source with a small degree of polarization, high efficiency and good light distribution characteristic.

## INDUSTRIAL APPLICABILITY

The semiconductor light-emitting element of the present invention has high light extraction efficiency, a sufficiently small degree of polarization, and good enough light distribution characteristic, and can be used as any of various light sources. The semiconductor light-emitting element of the present invention can be used particularly effectively as an ordinary illumination unit that is not required to have polarization property.

## REFERENCE SIGNS LIST

| | |
|---|---|
| **10** | substrate |
| **13** | light output member |
| **14** | flat light-emitting face |
| **20** | semiconductor multilayer structure |
| **21** | n-type nitride semiconductor layer |
| **22** | active layer region |
| **23** | p-type nitride semiconductor layer |
| **30** | n-type electrode |
| **31** | recess |
| **40** | p-type electrode |
| **50** | striped structure |
| **50a** | projection |
| **50b** | groove |
| **52** | slope |
| **53** | upper surface |
| **54** | plane that is parallel to ac plane |
| **55** | line of intersection between plane **54** and slope |
| **56** | cross-sectional shape of striped structure **50** |
| **60** | plane that is parallel to mc plane |
| **71** | light-emitting element chip |
| **72** | power supply |
| **73** | photodetector |
| **74** | polarizer |
| **101, 102, 103, 104, 105, 106, 107** | semiconductor light-emitting element |

## Claims

**1.** A semiconductor light-emitting element comprising:

an n-type nitride semiconductor layer;
a p-type nitride semiconductor layer;
an active layer region which includes an m-plane nitride semiconductor layer and which is interposed between the n-type nitride semiconductor layer and the p-type nitride semiconductor layer;
an n-type electrode which is electrically connected to the n-type nitride semiconductor layer;

a p-type electrode which is electrically connected to the p-type nitride semiconductor layer;

a light-emitting face, through which polarized light that has been produced in the active layer region is extracted out of the nitride semiconductor light-emitting element; and

a striped structure which is provided for the light-emitting face and which has a plurality of projections that run in a direction that defines either an angle of 5 degrees to 80 degrees or an angle of -80 degrees to -5 degrees with respect to the a-axis direction of the m-plane nitride semiconductor layer.

2. The semiconductor light-emitting element of claim 1, wherein the plurality of projections have at least one slope which is not parallel to the light-emitting face.

3. The semiconductor light-emitting element of claim 1 or 2, wherein the plurality of projections have a period of 300 nm or more.

4. The semiconductor light-emitting element of one of claims 1 to 3, wherein the plurality of projections have a period of 8 $\mu$m or less.

5. The semiconductor light-emitting element of one of claims 1 to 4, wherein in the striped structure, the plurality of projections run in a direction that defines either an angle of 30 degrees to 60 degrees or an angle of -60 degrees to -30 degrees with respect to the a-axis direction of the m-plane nitride semiconductor layer.

6. The semiconductor light-emitting element of one of claims 1 to 5, wherein the polarized light is produced in the active layer region so as to have a light distribution characteristic, of which the angle of radiation is wider in a c-axis direction than in the a-axis direction.

7. The semiconductor light-emitting element of one of claims 1 to 6, further comprising an n-type nitride semiconductor substrate which has first and second principal surfaces,

wherein the first principal surface is in contact with the n-type nitride semiconductor layer, and

wherein the light-emitting face is the second principal surface.

8. The semiconductor light-emitting element of one of claims 1 to 7, wherein the p-type nitride semiconductor layer has first and second principal surfaces, and

wherein the second principal surface is located closer to the active layer region, and

wherein the light-emitting face is the first principal surface.

9. The semiconductor light-emitting element of one of claims 1 to 8, further comprising:

an n-type nitride semiconductor substrate which is provided in contact with the n-type nitride semiconductor layer; and

a light output member which has first and second principal surfaces,

wherein the first principal surface is in contact with the other surface of the n-type nitride semiconductor substrate which is opposite from the surface that contacts with the n-type nitride semiconductor layer, and

wherein the light-emitting face is the second principal surface.

10. The semiconductor light-emitting element of one of claims 1 to 9, wherein the light output member has a refractive index of greater than one.

11. A method for fabricating a semiconductor light-emitting element, the method comprising the steps of:

forming a semiconductor multilayer structure on a substrate, the multilayer structure including an n-type nitride semiconductor layer, a p-type nitride semiconductor layer, and an active layer region which is interposed between the n-type and p-type nitride semiconductor layers and which includes an m-plane nitride semiconductor layer;

forming an n-type electrode which is electrically connected to the n-type nitride semiconductor layer and a p-type electrode which is electrically connected to the p-type nitride semiconductor layer; and

forming a striped structure, including a plurality of projections that run in a direction that defines either an angle of 5 degrees to 80 degrees or an angle of -80 degrees to -5 degrees with respect to the a-axis direction of the m-plane nitride semiconductor layer, on another surface of the substrate on which the semiconductor multilayer structure has not been formed.

12. A method for fabricating a semiconductor light-emitting element, the method comprising the steps of:

forming a semiconductor multilayer structure on a substrate, the multilayer structure including an n-type nitride semiconductor layer, a p-type nitride semiconductor layer, and an active layer region which is interposed between the n-type and p-type nitride semiconductor layers and which includes an m-plane nitride semiconductor layer; forming an n-type electrode which is electrically connected to the n-type nitride semiconductor layer and a p-type electrode which is electrically connected to the p-type nitride semiconductor layer; and forming a striped structure, including a plurality of projections that run in a direction that defines either an angle of 30 degrees to 60 degrees or an angle of -60 degrees to -30 degrees with respect to the a-axis direction of the m-plane nitride semiconductor layer, on another surface of the substrate on which the semiconductor multilayer structure has not been formed.

*FIG.1*

c PLANE (0001)

[0001]

c-AXIS
DIRECTION

c

$a_2$

$a_3$

$a_1$

m PLANE
(10-10)

*FIG.2*

(a)

N
Ga

(b)

N
Ga or In

[1-100]
[11-20]        [000-1]

m PLANE

(c)

N
Ga or In

[0001]
[1-100]        [-1-120]

c PLANE

*FIG.3*

101

40   23a

22a

23
22        22b  31    30  10a
21

20

10

INCIDENT LIGHT

REFLECTED LIGHT

50

TRANSMITTED
LIGHT

10b

# FIG.4

**(a)**

DIRECTION IN WHICH PROJECTIONS
OF STRIPED STRUCTURE RUN

**(b)**

**(c)**

**(d)**

*FIG.5*

(a)

$\alpha_{i1}$   $\alpha_{(i+1)1}$

(b)

$\alpha_{(i+1)2}$

$\alpha_{i2}$

$\alpha_{i1}$   $\alpha_{(i+1)1}$

(c)

$\alpha_{i1}$   $\alpha_{(i+1)1}$

*FIG.6*

(a)

50c 50b 50b
50a
50a 50b
50a 50b
50a 50b
50a 50b
50a 50b
50a 50b
50a
50a

50a

c
m a

(b)

50d 50a 50c 50a
50b
50b 50a
50b 50a
50b 50a
50b 50a
50b 50a
50b 50a
50b

50b

c
m a

FIG.7

*FIG.8*

(a)

(b)

*FIG.9*

50a

53

52

S-WAVE

S-WAVE

k1

k2

m

a

c

*FIG.10*

52

53

m

k1

k2

c

q

a

EP 2 602 836 A1

FIG.11

(a)

50a

β

c

m

a

(b)

50a

P

Pr

β

c

m

a

35

FIG.12

ANGLE $\beta$ [DEGREES] FORMED BETWEEN STRIPED STRUCTURE AND a-AXIS [°]

*FIG.13*

(a)

TRANSMITTED
LIGHT

61

INCIDENT LIGHT

m

a ◉ c

(b)

TRANSMITTED
LIGHT

61

INCIDENT
LIGHT

m

c ◉ a

(c)

53

52    52

TRANSMITTED
LIGHT

INCIDENT LIGHT

m

a ◉ c

*FIG.14*

*FIG.15*

*FIG.16*

*FIG.17*

*FIG.18*

*FIG.19*

*FIG.20*

*FIG.21*

(a)

(b)

*FIG.22*

(a)

c-AXIS DIRECTION

a-AXIS DIRECTION

(b)

(c)

FIG.23

*FIG.24*

(a)

a-AXIS DIRECTION

ANGLE β = 45°

0°

-30°

30°

ANGLE β = 0°

ANGLE β = 90°

-60°

60°

-90°

90°

(b)

ANGLE β = 90°

ANGLE β = 45°

0°

c-AXIS DIRECTION

ANGLE β = 0°

-30°

30°

-60°

60°

-90°

90°

*FIG.25*

*FIG.26*

*FIG.27*

*FIG.28*

**EP 2 602 836 A1**

| | | | |
|---|---|---|---|
| INTERNATIONAL SEARCH REPORT | | International application No. | |
| | | PCT/JP2011/004466 | |

A.  CLASSIFICATION OF SUBJECT MATTER
*H01L33/22*(2010.01)i, *H01L33/32*(2010.01)i, *H01S5/343*(2006.01)i

According to International Patent Classification (IPC) or to both national classification and IPC

B.  FIELDS SEARCHED

Minimum documentation searched (classification system followed by classification symbols)
H01L33/00-33/64, H01S5/00-5/50

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho    1971-2011   Toroku Jitsuyo Shinan Koho   1994-2011

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2008-305971 A  (Rohm Co., Ltd.),<br>18 December 2008 (18.12.2008),<br>entire text; all drawings<br>(Family: none) | 1-12 |
| A | JP 2009-117641 A  (Rohm Co., Ltd.),<br>28 May 2009 (28.05.2009),<br>entire text; all drawings<br>(Family: none) | 1-12 |
| A | JP 2009-043832 A  (Rohm Co., Ltd.),<br>28 February 2009 (28.02.2009),<br>entire text; all drawings<br>(Family: none) | 1-12 |

☒  Further documents are listed in the continuation of Box C.       ☐  See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>22 August, 2011 (22.08.11) | Date of mailing of the international search report<br>30 August, 2011 (30.08.11) |
| Name and mailing address of the ISA/<br>Japanese Patent Office | Authorized officer |
| Facsimile No. | Telephone No. |

Form PCT/ISA/210 (second sheet) (July 2009)

47

**INTERNATIONAL SEARCH REPORT**

International application No.

PCT/JP2011/004466

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2009-021349 A  (Rohm Co., Ltd.),<br>29 January 2009 (29.01.2009),<br>entire text; all drawings<br>(Family: none) | 1-12 |

Form PCT/ISA/210 (continuation of second sheet) (July 2009)

**EP 2 602 836 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001308462 A
- JP 2003332697 A
- JP 2008305971 A
- JP 2008109098 A
- JP 2001201746 A

**Non-patent literature cited in the description**

- *APPLIED PHYSICS LETTERS,* 2008, vol. 92, 091105
- *Thin Solid Films,* 2008, vol. 515, 768-770